(19) Europäisches Patentamt
European Patent Office
Office européen des brevets

(11) EP 2 196 505 B1

# (12) EUROPEAN PATENT SPECIFICATION

(45) Date of publication and mention of the grant of the patent:
**05.03.2014 Bulletin 2014/10**

(21) Application number: **08827828.8**

(22) Date of filing: **21.08.2008**

(51) Int Cl.:
***C09B 1/22*** *(2006.01)* ***C09B 67/14*** *(2006.01)*
***C09B 67/22*** *(2006.01)* ***G02B 5/20*** *(2006.01)*

(86) International application number:
**PCT/JP2008/064926**

(87) International publication number:
**WO 2009/025325 (26.02.2009 Gazette 2009/09)**

## (54) PIGMENT COMPOSITION FOR COLOR FILTER AND COLORING COMPOSITION FOR COLOR FILTER

PIGMENTZUSAMMENSETZUNG FÜR FARBFILTER UND FARBGEBENDE ZUSAMMENSETZUNG FÜR FARBFILTER

COMPOSITION DE PIGMENT POUR FILTRE COLORE ET COMPOSITION COLORANTE POUR FILTRE COLORE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **22.08.2007 JP 2007215419**

(43) Date of publication of application:
**16.06.2010 Bulletin 2010/24**

(73) Proprietor: **Toyo Ink Mfg. Co. Ltd.**
**Tokyo 104-0031 (JP)**

(72) Inventors:
- **UENO, Yoshimitsu**
  **Tokyo 104-0031 (JP)**
- **TOYODA, Ichiro**
  **Tokyo 104-0031 (JP)**
- **HAMADA, Naoki**
  **Tokyo 104-0031 (JP)**

(74) Representative: **Bauch-Koepe, Katharina Anna**
**Koepe & Partner**
**Robert-Koch-Strasse 1**
**80538 München (DE)**

(56) References cited:
**JP-A- 9 272 812** **JP-A- 09 272 812**
**JP-A- 10 245 501** **JP-A- 10 245 501**
**JP-A- 10 245 502** **JP-A- 10 245 502**
**JP-A- 2000 273 346** **JP-A- 2002 179 976**
**JP-A- 2005 029 633** **JP-A- 2007 138 135**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 196 505 B1

## Description

The present invention relates to a method for manufacturing a pigment composition and to a method for manufacturing a coloring composition that are used for the manufacture of color filters used in color liquid crystal display apparatuses and solid image pick-up elements.

BACKGROUND ART

A liquid crystal display apparatus performs display when a liquid crystal layer interposed between two sheets of polarizing plates regulates the degree of polarization of a light which has passed through the first polarizing plate, and controls the amount of the light that passes through the second polarizing plate. Color display is made possible by providing a color filter between the two sheets of polarizing plates. In recent years, this apparatus increasingly finds use in television, PC monitors and the like.

A color filter is formed from two or more kinds of fine strip-shaped (stripe) filter segments having different colors that are disposed in a parallel or intersecting fashion, or from such fine filter segments that are disposed in a horizontally and vertically uniform arrangement, on the surface of a transparent platform made of glass or the like. The filter segments are very fine with a size of several micrometers to several hundred micrometers, and are disposed in a predetermined, orderly arrangement for each color. Generally, in a color liquid crystal display apparatus, a transparent electrode for driving liquid crystals is formed on the color filter by deposition or sputtering. Furthermore, an alignment film for orienting the liquid crystals in a constant direction is formed on the transparent electrode. The process for forming these transparent electrode and alignment film is carried out at a high temperature of generally 200°C or higher, or of 230°C or higher in some cases. Therefore, as for the method for producing a color filter, a method called pigment dispersion method, which makes use of a pigment having excellent light resistance and heat resistance as a colorant, currently constitutes the mainstream.

However, color filters produced by the pigment dispersion method generally have posed a problem that the scattering of light or the like caused by the pigment leads to a disturbance in the degree of polarization controlled by the liquid crystals. Accordingly, light leakage occurred when light shielding was needed, or a decrease in the amount of transmitted light occurred when light transmission was needed. Thereby, there has been a problem that the ratio of brightness (contrast) in the display apparatus is low at the time of shielding and at the time of transmission.

Among the pigments used for color filters, dianthraquinone pigments, perylene-based pigments, diketopyrrolopyrrole-based pigments and the like have been traditionally used in the production of red color filter. Among these, dianthraquinone pigments in particular exhibit high contrast when formed into films, and also have excellent light resistance or heat resistance, and therefore, these pigments are being heavily put to use in this application. However, in recent years, there has been a demand for a further enhancement of contrast, but it was difficult to achieve the purpose with the conventionally used dianthraquinone pigments.

In general, pigments having high coloring power or vivid color tone are in many cases constituted of fine primary particles. Particularly, those pigments used in color filters are frequently subjected even to further micronization as compared with conventional pigments, so as to enhance the contrast of the films.

As a method of pigmentization for preparing fine pigment particles, there is known a method of dissolving a pigment in an acid such as sulfuric acid or phosphoric acid, and then injecting the sulfuric acid solution into water to induce precipitation. There is also known a method of mechanically kneading a pigment with a mixture containing a water-soluble inorganic salt and a water-soluble organic solvent (hereinafter, described as salt milling method), or the like.

As a technique for the micronization of dianthraquinone pigments according to these methods, there have been disclosed methods of Patent Documents 1 to 5.

Among these, Patent Document 1 discloses a method for pigment production having a process of continuously adding a sulfuric acid solution of a condensed polycyclic type organic red pigment such as a dianthraquinone pigment, into flowing water to thereby precipitate the condensed polycyclic type organic red pigment. According to this method, a conventional pigment can be easily micronized. However, since the method does not make use of a crystal growth preventing agent, a pigment dispersant or the like, the degree of micronization and dispersibility were not so sufficient as to achieve the high contrast required of color filters in recent years. Accordingly, it was not possible to obtain color filters having satisfactory product quality.

Patent Document 2 discloses a method for producing a treated pigment by co-dissolving an organic pigment with an derivative of the organic pigment having a sulfonic acid group or a salt thereof in a strong acid, and taking the solution out into water. According to this method, a mixture of an organic pigment and a derivative of the organic pigment in a microscopic scale, or an organic pigment subjected to coating with a derivative of the organic pigment at the surface, can be produced. However, this method could not achieve sufficient micronization of the organic pigment. Furthermore, in the case of dispersing the organic pigment using a dispersant resin having a basic functional group, the dispersion was easily achieved; however, in a dispersion system making use of a resin having an acidic functional group, the

dispersibility of the organic pigment was insufficient.

Patent Documents 3 to 5 disclose methods for producing treated pigments by micronizing a mixture of a pigment derivative or an anthraquinone derivative and a C.I. Pigment Red 177 by the salt milling method, and subjecting the particles to particle size regulation. Patent Document 6 discloses a mixture of C. I. pigment red 179, C.I. pigment red 177, C.I. pigment yellow 139, C.I. pigment violet 23, an anthraquinone pigment derivative, a resin dispersant, an acrylic resin solution, and cyclohexanone which is subsequentially dispersed in an Eiger Mill by using zirconia beads having a diameter of 0.5 mm for 10 hours. According to these methods, a fine, treated pigment having satisfactory dispersibility can be prepared. However, the degree of micronization and dispersibility were not so sufficient as to obtain the required high contrast.

Patent Document 1: JP-A No. 09-208848

Patent Document 2: JP-A No. 2005-29633

Patent Document 3: JP-A No. 09-272812

Patent Document 4: JP-A No. 10-245501

Patent Document 5: JP-A No. 10-245502

Patent Document 6: JP No. 2007-138135

DISCLOSURE OF INVENTION

PROBLEM TO BE SOLVED BY THE INVENTION

It is an object of the present invention to provide method for manufacturing a pigment composition and a method for manufacturing a coloring composition for color filter, which have satisfactory dispersibility and exhibit high contrast when formed into films.

MEANS FOR SOLVING PROBLEM

The present invention relates to a method for manufacturing a pigment composition for color filter and a method for manufacturing a coloring composition for color filter as follows.

(1) A method for manufacturing a pigment composition for color filter, comprising the steps of:

dissolving C.I. Pigment Red 177 and a pigment derivative of the formula of Q-Am having a main structure "Q" selected from the group consisting of the following formulas (1-(i)) to (1-(viii)) and having a basic or neutral substituent represented by "-Am" in which "A" is selected from a substituted or unsubstituted phthalimidomethyl group, a group represented by the following formula (2), a group represented by the following formula (3) or a group represented by formula $H-X_1-X_2-X_5-$, and "m" represents an integer from 1 to 8, in sulfuric acid; subsequently mixing them with water to induce precipitation; and removing acidic components,

Formula (1)

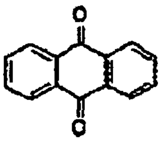

(i)

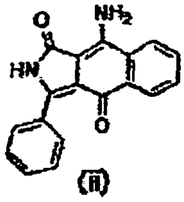

(ii)

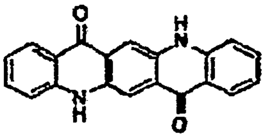

(iii)

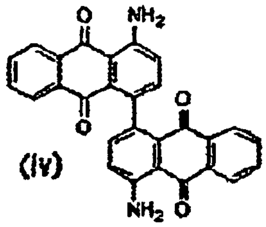

(iv)

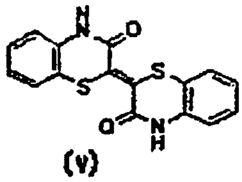

(v)

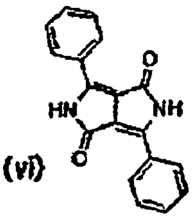

(vi)

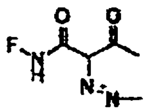

(vii)

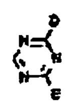

(viii)

{wherein "F" is selected from a phenyl group, a phthalimide group, a benzimidazolone group, a naphthalimide group, and the same groups but having substituents; and "$X_1$", $X_2$, "$X_5$", "D" and "E" have the same meanings as defined for thefollowing formulas (2) and (3)}:

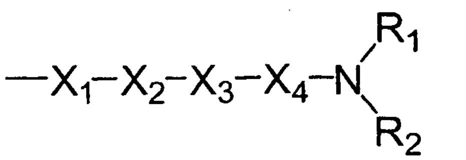

Formula (2)

{wherein "$X_1$" is selected from -NH-, a single bond linking between adjacent atoms, $-SO_2-$, -CO-, $-SO_2NR'-$, -CONR'-and $-CH_2NR'COCH_2NR'-$

"$X_2$" is selected from a single bond linking between adjacent atoms, an alkylene group having 20 or fewer carbon atoms, an alkenylene group having 20 or fewer carbon atoms, an arylene group having 20 or fewer carbon atoms, a heteroaromatic ring having 20 or fewer carbon atoms, and the same groups but having substituents (these groups may be linked to each other via a divalent linking group selected from -NR'-, -O-, $-SO_2-$or -CO-)

"$X_3$" is selected from a single bond linking between adjacent atoms, $-SO_2NR'$ and -CONR'-

"$X_4$" is selected from a single bond linking between adjacent atoms, an alkylene group having 20 or fewer carbon atoms, an alkenylene group having 20 or fewer carbon atoms, an arylene group having 20 or fewer carbon atoms, and the same groups but having substituents (these groups may be linked to each other via a divalent linking group selected from -NR'-, -O-, $-SO_2-$ or -CO-),

"$R_1$" and "$R_2$" are each independently selected from a hydrogen atom, an alkyl group having 20 or fewer carbon atoms, an alkenyl group having 20 or fewer carbon atoms, and the same groups but having substituents, and $R_1$ and $R_2$ are present singly, are joined to form a ring, or are joined together with a nitrogen atom, an oxygen atom or a sulfur atom to form a heterocycle; and

"R'" is selected from a hydrogen atom, an alkyl group having 20 or fewer carbon atoms, an alkenyl group having 20 or fewer carbon atoms, an aryl group having 20 or fewer carbon atoms, and the same groups but having substituents,

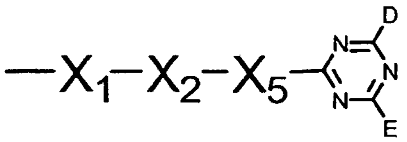

Formula (3)

{wherein "$X_1$" and "$X_2$" have the same meaning as defined for the formula (2),
"$X_5$" represents -NR'- or -O-, provided that R' has the same meaning as defined for the formula (2), and
"D" and "E" are each independently selected from a group represented by the following formula (4), a group represented by the following formula (5), a group represented by the following formula (6), $-O-(CH_2)_n-R_8$, $-OR_9$, $-NR_{10}R_{11}$, -Cl and -F,
"$R_8$" represents a nitrogen-containing heterocycle residue,
"R", "$R_{10}$" and "$R_{11}$" are each independently selected from a hydrogen atom, an alkyl group having 20 or fewer carbon atoms, an alkenyl group having 20 or fewer carbon atoms, an aryl group having 20 or fewer carbon atoms, and the same groups but having substituents, and
"n" represents an integer from 0 to 20,
provided that any one of D and E is a group represented by the following formula (4) or (5), $-O-(CH_2)_n-R_8$, $-OR_9$, or $-NR_{10}R_{11}$},

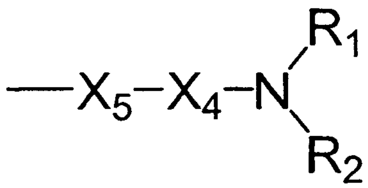

Formula (4)

{wherein $X_5$, $X_4$, $R_1$ and $R_2$ have the same meanings as defined for the formula (2) or formula (3),

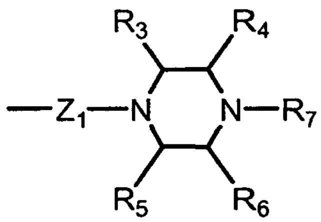

Formula (5)

wherein "$Z_1$" is selected from a single bond linking the triazine ring with a nitrogen atom, -NR'-, -NR'-G-CO-, -NR'-G-CONR''-, -NR'-G-$SO_2$-, -NR'-G-$SO_2$NR''-, -O-G-CO-, -O-G-CONR'-, -O-G-$SO_2$- and -O-G-$SO_2$NR'-,
"G" is selected from an alkylene group having 20 or fewer carbon atoms, an alkenylene group having 20 or fewer carbon atoms, an arylene group having 20 or fewer carbon atoms, and the same groups but having substituents, and
"R'" and "R''" are each independently selected from a hydrogen atom, an alkyl group having 20 or fewer carbon atoms, an alkenyl group having 20 or fewer carbon atoms, an aryl group having 20 or fewer carbon atoms, and the same groups but having substituents;
$R_3$, $R_4$, $R_5$ and $R_6$ are each independently selected from a hydrogen atom, an alkyl group having 20 or fewer carbon atoms, an alkenyl group having 20 or fewer carbon atoms, an aryl group having 20 or fewer carbon atoms, and the same groups but having substituents; and
"$R_7$" is selected from an alkyl group having 20 or fewer carbon atoms, an alkenyl group having 20 or fewer carbon atoms, and the same groups but having substituents}, and

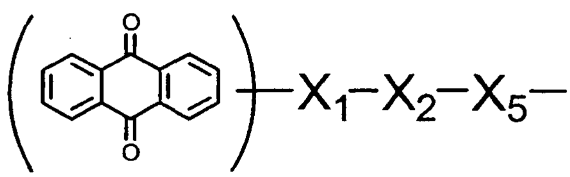

Formula (6)

{wherein "$X_1$", $X_2$ and $X_5$ have the same meanings as defined for the formula (2) or formula (3).

(2) The method for manufacturing a pigment composition for color filter according to (1), wherein the pigment derivative is an anthraquinone derivative represented by the following formula (7) :

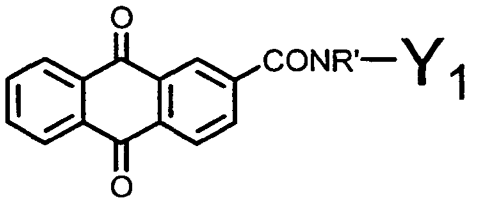

Formula (7)

{wherein $Y_1$ represents a group represented by the following formula (8) or the following formula (9)}:

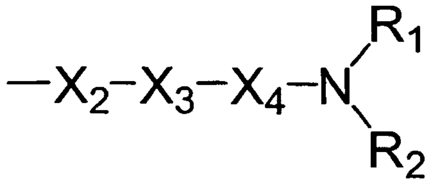

Formula (8)

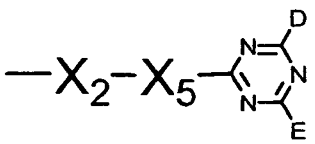

Formula (9)

wherein $X_2$, $X_3$, $X_4$, $X_5$, $R_1$, $R_2$, D and E have the same meanings as defined for the formula (2) or formula (3)}.

(3) The method for manufacturing a pigment composition for color filter according to (1) or (2), wherein the content of the pigment derivative is 0.5% by weight to 30% by weight based on the total weight of the C.I. Pigment Red 177 and the pigment derivative.

(4) The method for manufacturing a pigment composition for color filter, comprising the pigment composition according to any one of (1) to (3), and a red pigment other than the C.I. Pigment Red 177 or an orange pigment.

(5) The method for manufacturing a pigment composition for color filter according to (4), wherein the red pigment other than the C.I. Pigment Red 177 or the orange pigment is at least one pigment selected from C.I. Pigment Red 254, Pigment Red 255, C.I. Pigment Red 264, C.I. Pigment Red 207, C.I. Pigment Red 48:1, C.I. Pigment Orange 71 and C.I. Pigment Orange 73.

(6) A method for manufacturing a pigment composition for color filter, comprising the manufacturing steps of the method for manufacturing a pigment composition according to any one of (1) to (5), and adding a yellow pigment.

(7) The method for manufacturing a pigment composition for color filter according to (6), wherein the yellow pigment is at least one pigment selected from C.I. Pigment Yellow 138, C.I. Pigment Yellow 139, C.I. Pigment Yellow 150, C.I. Pigment Yellow 185 and C.I. Pigment Yellow 13.

(8) A method for manufacturing a coloring composition for color filter, comprising the manufacturing steps of the method for manufacturing a pigment composition according to any one of (1) to (7), and adding a pigment carrier formed from a transparent resin, a precursor thereof or a mixture of these.

EFFECT OF THE INVENTION

The method for manufacturing a pigment composition for color filter of the present invention comprises the steps of dissolving C.I. Pigment Red 177 and a specific pigment derivative in sulfuric acid, and then mixing the solution with water to precipitate pigment particles (hereinafter, this method is described as acid pasting). According to this method, the micronizing effect of the specific pigment derivative on the C.I. Pigment Red 177 can be manifested to the maximum, and therefore there is obtained a pigment composition containing very fine particles of the C.I. Pigment Red 177 compared with conventional C.I. Pigment Red 177 pigments. Furthermore, due to the effect of the specific pigment derivative as a pigment dispersant, there is obtained a pigment composition having very satisfactory dispersibility compared with untreated C.I. Pigment Red 177 pigments. When this pigment composition and a coloring composition containing the pigment composition are put to use, it is made possible to produce color filters with high contrast.

BEST MODE FOR CARRYING OUT THE INVENTION

The present invention relates to a method for manufacturing a pigment composition for color filter that comprises the steps of dissolving C.I. Pigment Red 177 and a pigment derivative of the formula: Q-Am, which has a main structure Q selected from the group consisting of the following formulas (1-(i)) to (1-(viii)) and has a basic or neutral substituent represented by -Am (wherein A represents any one of a phthalimidomethyl group which may have a substituent, a group represented by the following formula (2), a group represented by the following formula (3), or a group represented by the formula: H-$X_1$-$X_2$-$X_5$-; and m represents an integer from 1 to 8) in sulfuric acid, subsequently mixing the solution with water to induce precipitation, and removing acidic components:

Formula (1)

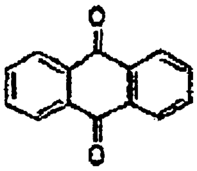

(i)

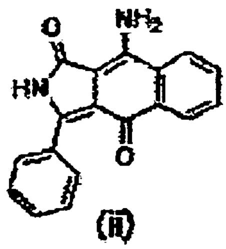

(ii)

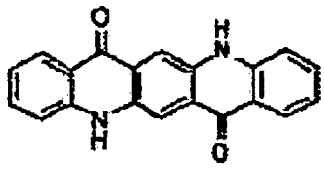

(iii)

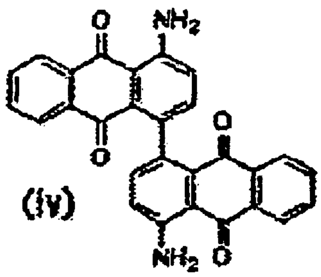

(iv)

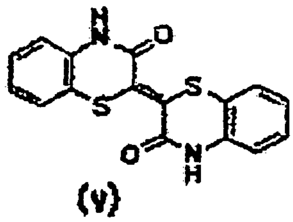

(v)

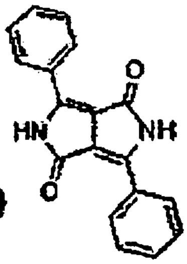

(vi)

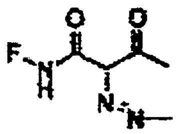

(vii)

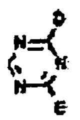

(viii)

{wherein F is a group selected from a phenyl group, a phthalimide group, a benzimidazolone group and a naphthalimide group, and may contain a substituent; and $X_1$, $X_2$, $X_5$, D and E have the same meanings as defined for the following formulas (2) and (3)}:

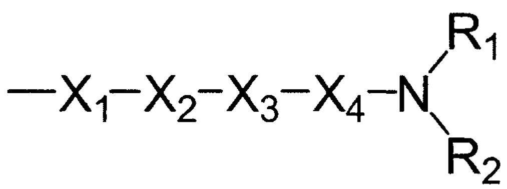

Formula (2)

{wherein $X_1$ represents any one of -NH-, a single bond linking between adjacent atoms, -$SO_2$-, -CO-, -$SO_2$NR'-, -CONR'-, and -$CH_2$NR'$COCH_2$NR'- ;

$X_2$ represents any one of a single bond linking between adjacent atoms, an alkylene group having 20 or fewer carbon atoms which may have a substituent, an alkenylene group having 20 or fewer carbon atoms which may have a substituent, an arylene group having 20 or fewer carbon atoms which may have a substituent, and a heteroaromatic ring having 20 or fewer carbon atoms which may have a substituent (these groups may be linked to each other via a divalent linking group selected from -NR'-, -O-, -$SO_2$- and -CO-);

$X_3$ represents any one of a single bond linking between adjacent atoms, -$SO_2$NR'- and -CONR'-;

$X_4$ represents any one of a single bond linking between adjacent atoms, an alkylene group having 20 or fewer carbon

atoms which may have a substituent, an alkenylene group having 20 or fewer carbon atoms which may have a substituent, and an arylene group having 20 or fewer carbon atoms which may have a substituent (these groups may be linked to each other via a divalent linking group selected from -NR'-, -O-, $-SO_2-$ or -CO-) ; and

$R_1$ and $R_2$ each independently represent any one of a hydrogen atom, an alkyl group having 20 or fewer carbon atoms which may have a substituent, and an alkenyl group having 20 or fewer carbon atoms which may have a substituent; and $R_1$ and $R_2$ may be joined to form a heterocyclic structure which may further include a nitrogen atom, an oxygen atom or a sulfur atom and may have a substituent;

provided that R' represents any one of a hydrogen atom, an alkyl group having 20 or fewer carbon atoms which may have a substituent, an alkenyl group having 20 or fewer carbon atoms which may have a substituent, and an aryl group having 20 or fewer carbon atoms which may have a substituent},

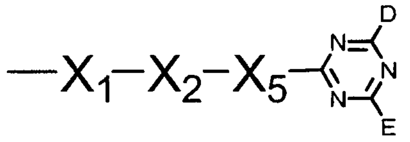

Formula (3)

{wherein $X_1$ and $X_2$ have the same meanings as defined for the formula (2);

$X_5$ represents -NR'- or -O-, provided that R' has the same meaning as defined for the formula (2); and

D and E each independently represent any one of a group represented by the following formula (4), a group represented by the following formula (5), a group represented by the following formula (6), $-O-(CH_2)_n-R_8$, $-OR_9$, $-NR_{10}R_{11}$, -Cl, and -F (wherein $R_8$ represents a nitrogen-containing heterocycle residue which may have a substituent; $R_9$, $R_{10}$ and $R_{11}$ each independently represent a hydrogen atom, an alkyl group having 20 or fewer carbon atoms which may have a substituent, an alkenyl group having 20 or fewer carbon atoms which may have a substituent, or an aryl group having 20 or fewer carbon atoms which may have a substituent; and n represents an integer from 0 to 20); and any one of D and E is a group represented by the following formula (4) or (5), $-O-(CH_2)_n-R_8$, $-OR_9$, or $-NR_{10}R_{11}$},

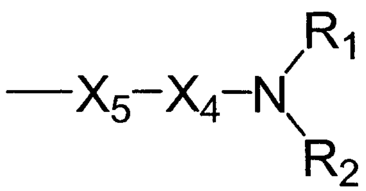

Formula (4)

{wherein $X_5$, $X_4$, $R_1$ and $R_2$ have the same meanings as defined for the formula (2) or formula (3)},

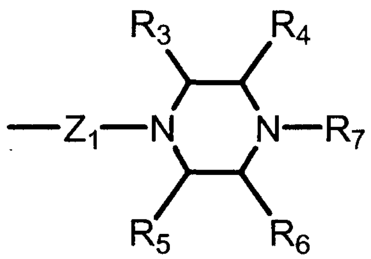

Formula (5)

{wherein $Z_1$ represents any one of a single bond linking the triazine ring and a nitrogen atom, -NR'-, -NR'-G-CO-, -NR'-G-CONR"-, $-NR'-G-SO_2-$, $-NR'-G-SO_2NR''-$, -O-G-CO-, -O-G-CONR'-, $-O-G-SO_2-$ and $-O-G-SO_2NR'-$ (wherein G represents an alkylene group having 20 or fewer carbon atoms which may have a substituent, an alkenylene group having 20 or fewer carbon atoms which may have a substituent, or an arylene group having 20 or fewer carbon atoms which may have a substituent; and R' and R" each independently represent a hydrogen atom, an alkyl group having 20 or fewer carbon atoms which may have a substituent, an alkenyl group having 20 or fewer carbon atoms which may have a substituent, or an aryl group having 20 or fewer carbon atoms which may have a substituent);

$R_3$, $R_4$, $R_5$ and $R_6$ each independently represent any one of a hydrogen atom, an alkyl group having 20 or fewer carbon atoms which may have a substituent, an alkenyl group having 20 or fewer carbon atoms which may have a substituent, and an aryl group having 20 or fewer carbon atoms which may have a substituent; and

$R_7$ represents an alkyl group having 20 or fewer carbon atoms which may have a substituent, or an alkenyl group having 20 or fewer carbon atoms which may have a substituent}, and

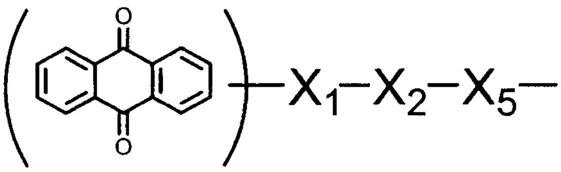

Formula (6)

{wherein $X_1$, $X_2$ and $X_5$ have the same meanings as defined for the formula (2) or formula (3)}.

In regard to the pigment derivative, the "substituent" in the phrase "having substituents" and "may have a substituent" may be a halogen atom, a nitro group, an amino group, an alkyl group, an alkoxy group, a carbamoyl group, a sulfamoyl group, a carboxyl group, a hydroxyl group, a mercapto group or the like.

The bonding position of Am in the pigment derivative of formula Q-Am is not particularly limited.

If the formula (1-(i)) is selected as the main structure Q, an anthraquinone derivative is obtained as the pigment derivative. The anthraquinone derivative can be synthesized by a known method.

When A that is linked to the main structure Q is a phthalimidomethyl group which may have a substituent, the anthraquinone derivative can be synthesized by a method of reacting anthraquinone with paraformaldehyde and phthalimide which may have a substituent in sulfuric acid, for example, a method described in JP-A No. 55-108466. Examples of the substituent which may be carried by the phthalimidomethyl group include a halogen atom, a nitro group, an amino group, an alkyl group, an alkoxyl group, a carbamoyl group, a sulfamoyl group, a carboxyl group and the like.

When A is a group represented by the formula (2), the anthraquinone derivative can be synthesized by a method of subjecting anthraquinone to chlorosulfonation or chloroacetylaminomethylation, and then reacting the product with an amine. Synthesis examples according to these methods are described in JP-A No. 56-167762, JP-A No. 05-331398, and the like. Furthermore, the anthraquinone derivative can also be synthesized according to a method of synthesizing 2-methylanthraquinone from toluene and phthalic anhydride, subsequently oxidizing the methyl group to obtain anthraquinone-2-carboxylic acid, further chlorinating the carboxyl group, and reacting the resultant with an amine. Synthesis examples according to this method are described in JP-A No. 56-32549.

When A is a group represented by the formula (3), the anthraquinone derivative can be synthesized by a reaction between an intermediate synthesized by reacting cyanuric chloride with an amine or alcohol having an acetylamino group and an amine such as N,N-diethylaminopropylamine or an alcohol and hydrolyzing the acetylamino group, and a compound obtained by subjecting anthraquinone to chlorosulfonation or chloroacetylaminomethylation, or the anthraquinone-2-carboxylic acid chloride synthesized as described above. Synthesis examples according to this method are described in JP-A No. 63-305173.

Specific examples 101 to 132 of the anthraquinone derivatives will be shown in the following, but the examples are not intended to be limited to these.

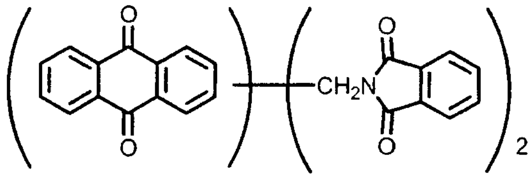

(101)

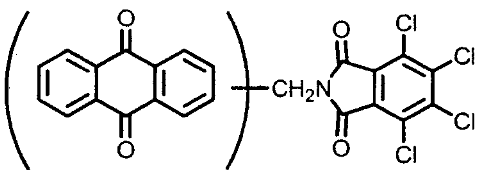

(102)

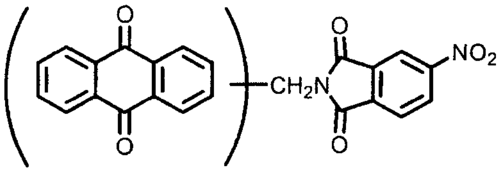

(103)

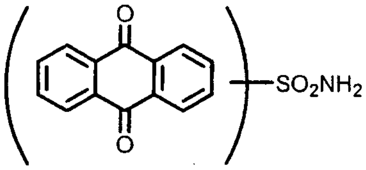

(104)

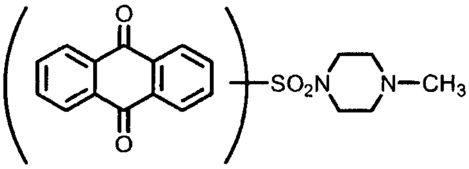

(105)

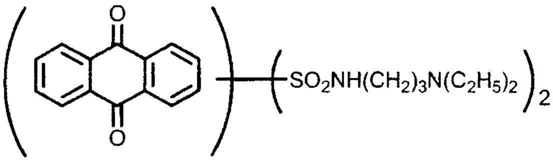

(106)

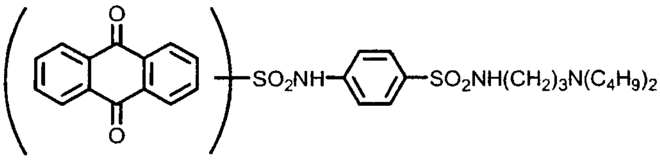

(107)

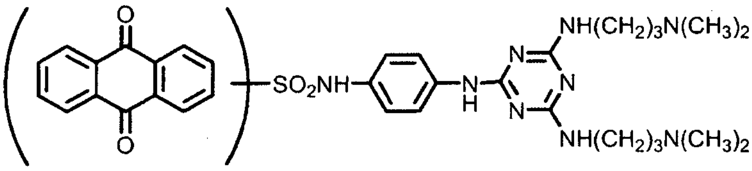

(108)

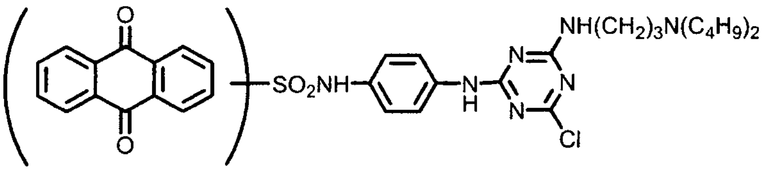

(109)

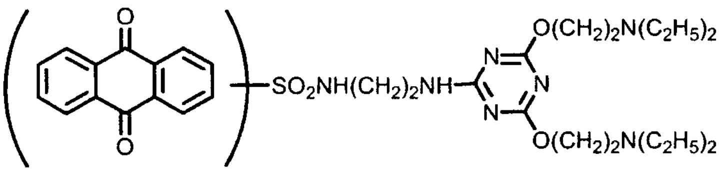

(110)

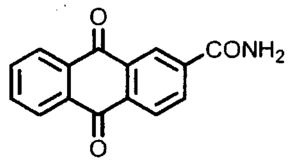

(111)

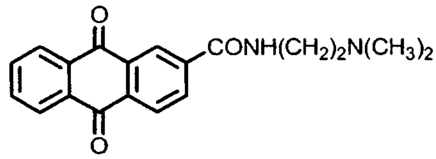

(112)

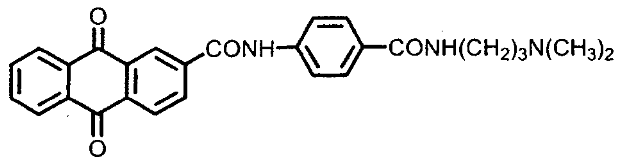

(113)

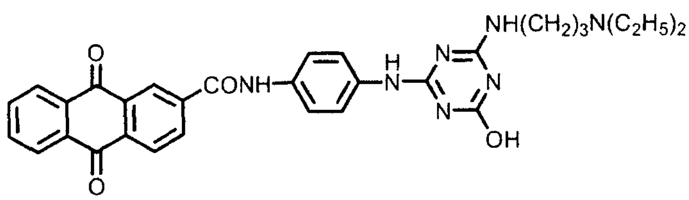

(114)

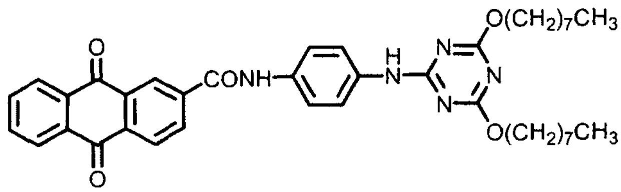

(115)

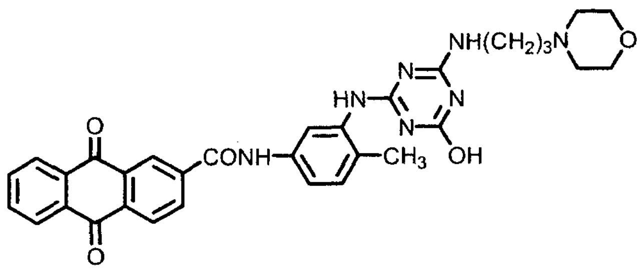

(116)

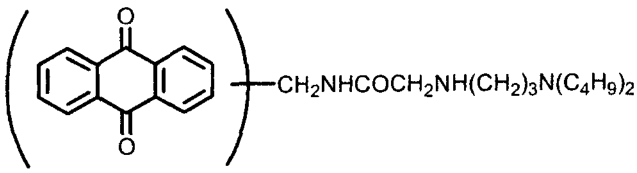

(117)

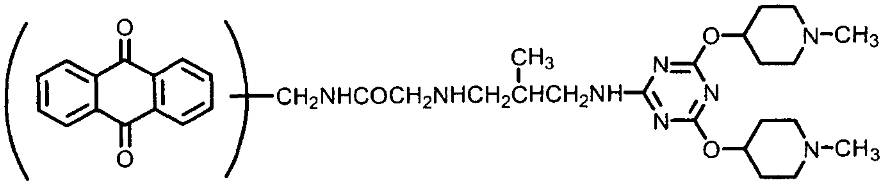

(118)

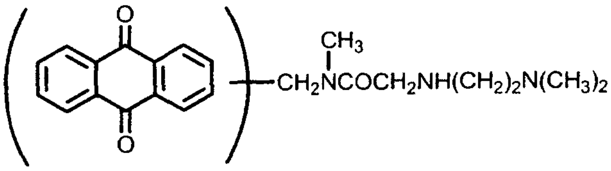

(119)

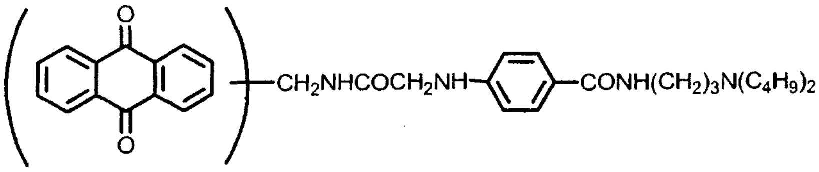

(120)

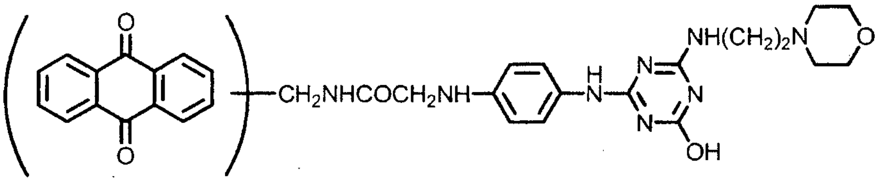

(121)

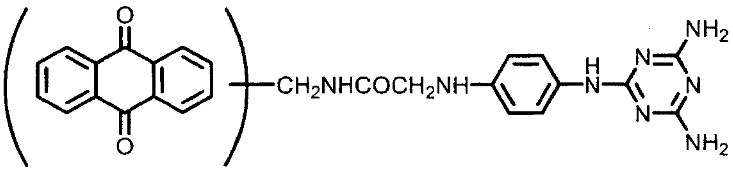

(122)

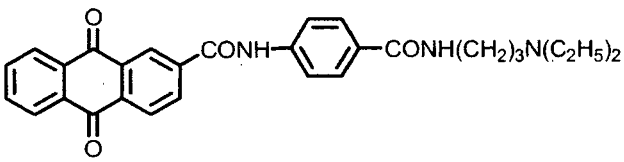

(123)

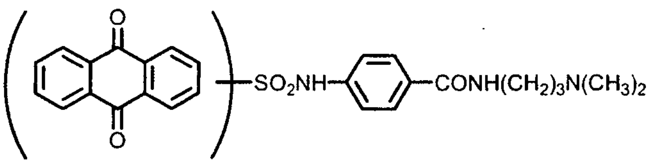

(124)

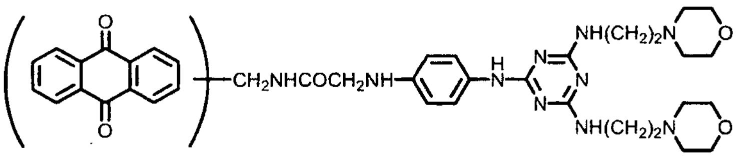

(125)

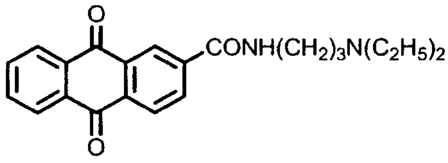

(126)

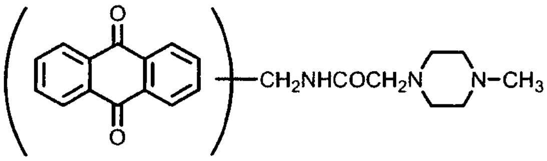

(127)

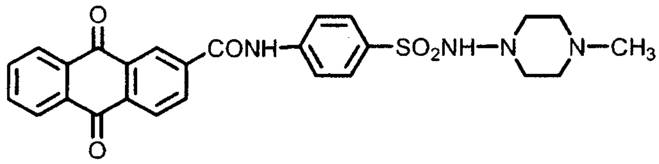

(128)

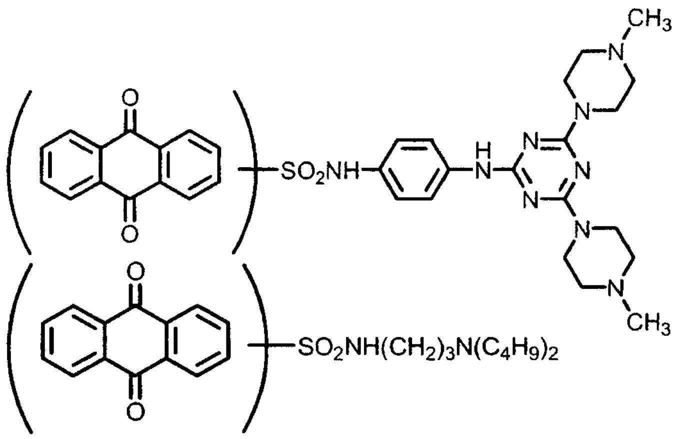

(129)

(130)

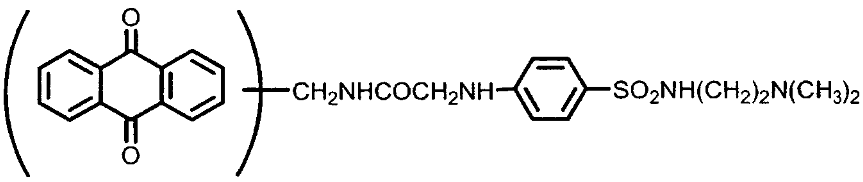

(131)

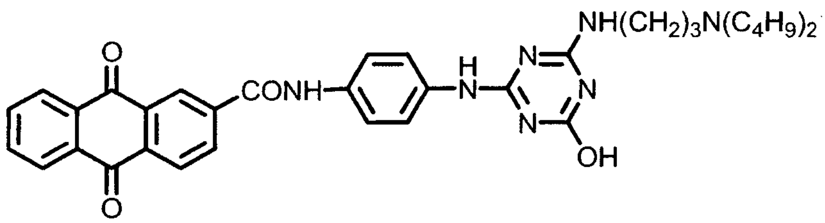

(132)

Among these, an anthraquinone derivative represented by the following formula (7) is particularly preferred to be used for the purpose of the present invention, since the derivative has very high micronizing effects and dispersing effects on C.I. Pigment Red 177.

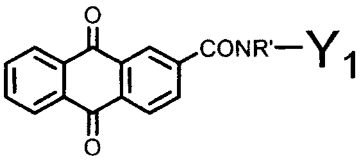

Formula (7)

{wherein $Y_1$ represents a group represented by the following formula (8) or a group represented by the following formula (9)}:

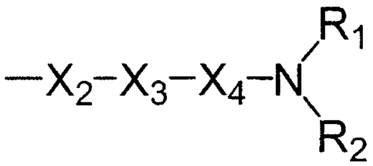

Formula (8)

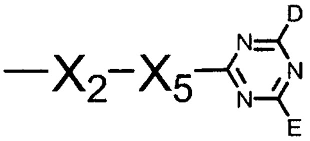

Formula (9)

{wherein $X_2$, $X_3$, $X_4$, $X_5$, $R_1$, $R_2$, D and E have the same meanings as defined for the formula (2) or formula (3)}.

The anthraquinone derivative represented by the formula (7) can be synthesized by allowing an intermediate obtained by synthesizing 2-methylanthraquinone from toluene and phthalic anhydride, subsequently oxidizing the methyl group to obtain anthraquinone-2-carboxylic acid, and chlorinating the carboxyl group, to react with an amine, or by allowing cyanuric chloride to react with an intermediate obtained by reacting an amine or alcohol having an acetylamino group with an amine such as N,N-diethylaminopropylamine or an alcohol, and then hydrolyzing the acetylamino group.

Next, the pigment derivatives having the structures of the formulas (1-(ii)) to (1-(viii)) as the main structure will be explained. The formula (ii) corresponds to benzoisoindole, the formula (iii) to quinacridone, the formula (iv) to diaminodianthraquinone, the formula (v) to thiazine-indigo, the formula (vi) to diketopyrrolopyrrole, the formula (vii) to an azo compound, and the formula (viii) to a triazine compound. Examples of the pigment derivatives having the structures of (ii) to (viii) as the main structure include the following pigment derivatives 201 to 237. These may be used singly or in combination, or may be used in combination with the pigment derivative having the anthraquinone of the formula (1- (i)) as the main structure. Among them, pigment derivatives 201, 202, 214, 217, 229, 230 and 236 are preferred.

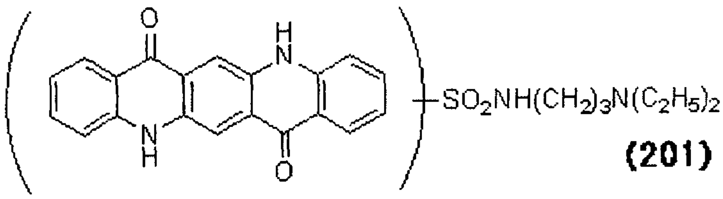

(201)

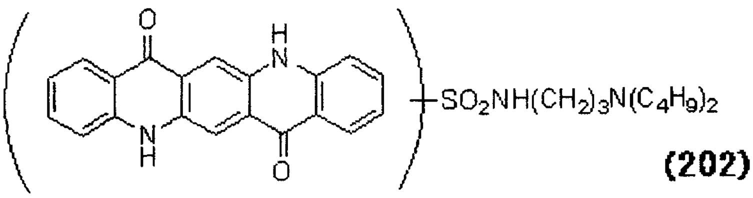

(202)

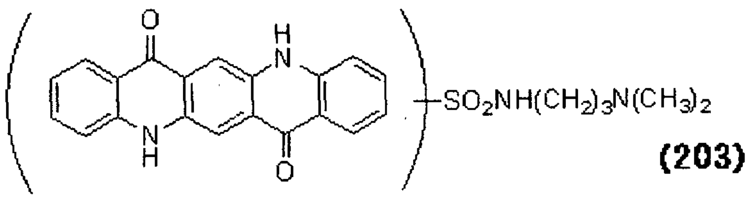

(203)

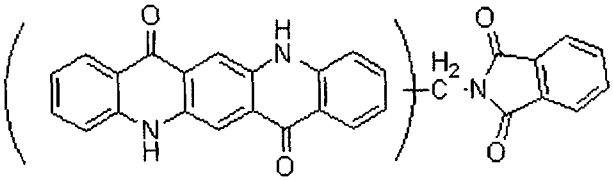

(204)

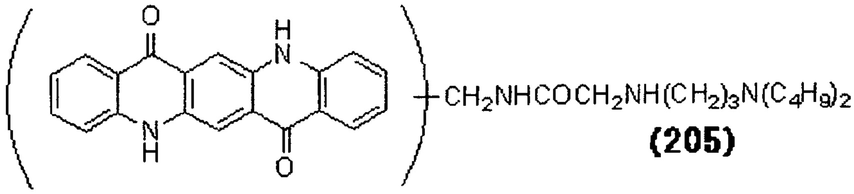

(205)

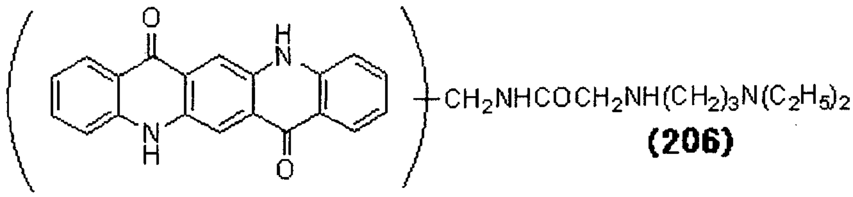

(206)

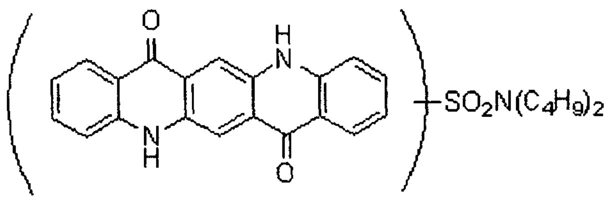

(207)

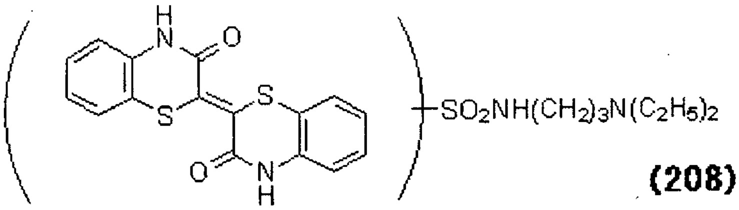

(208)

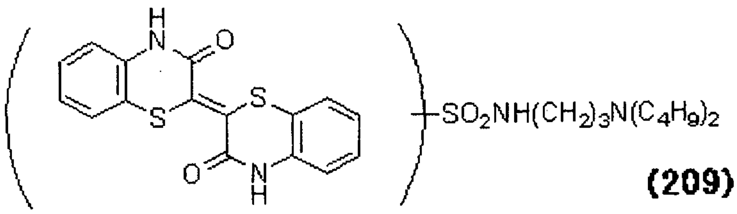

(209)

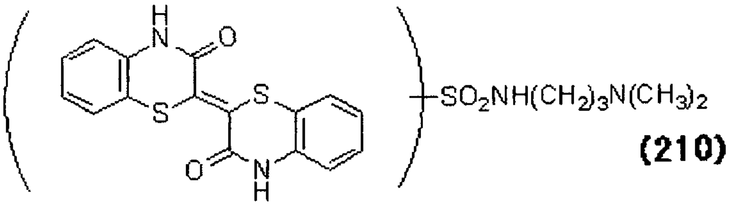

(210)

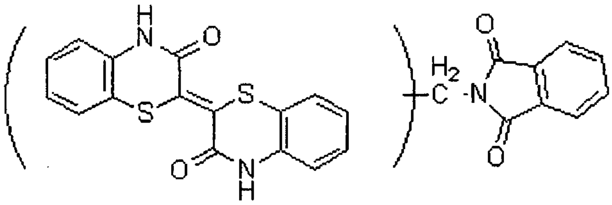

(211)

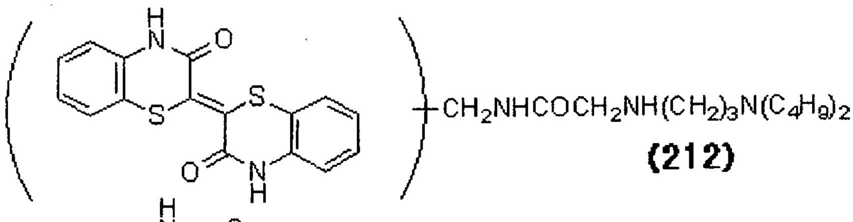

(212)

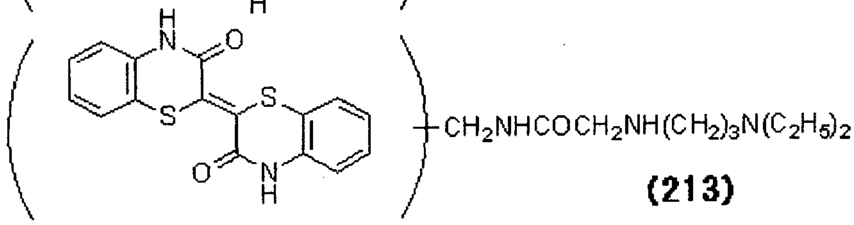

(213)

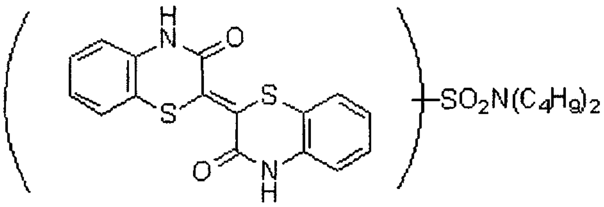

(214)

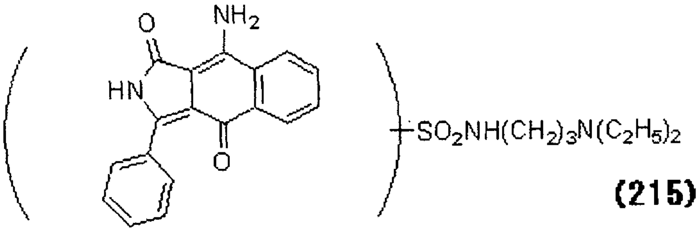

(215)

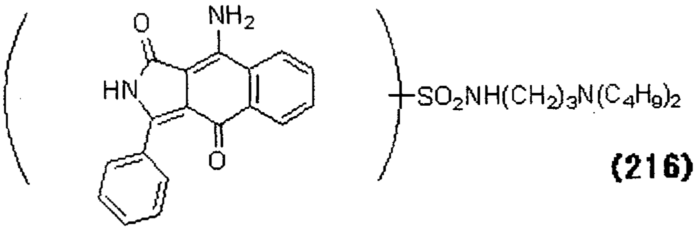

(216)

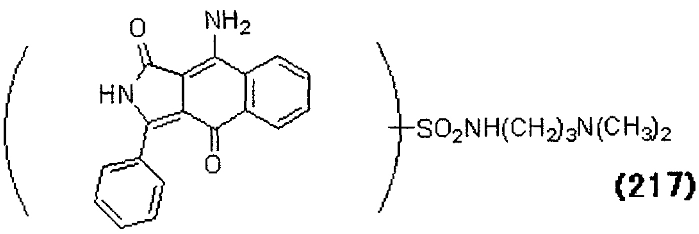

(217)

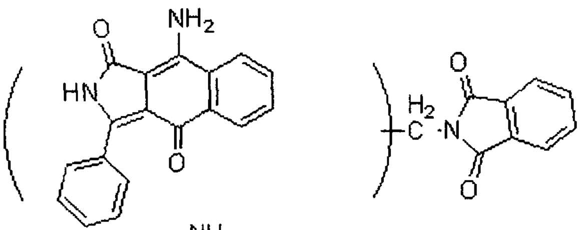

(218)

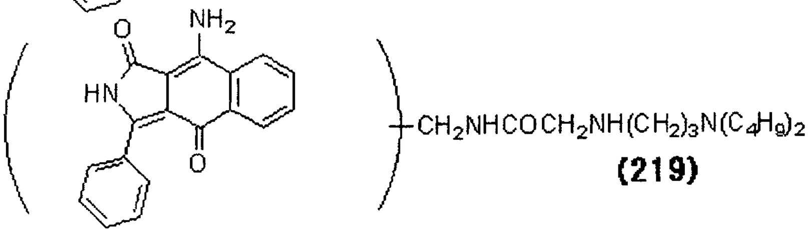

(219)

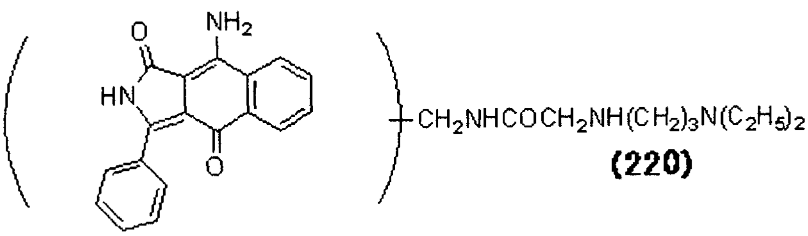

(220)

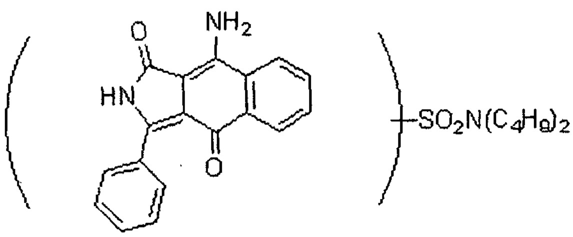

(221)

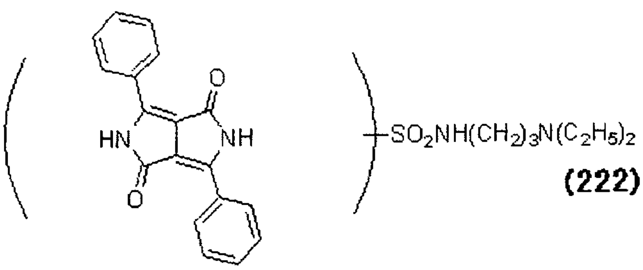

(222)

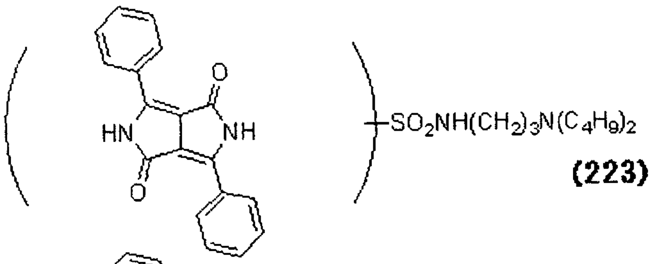

(223)

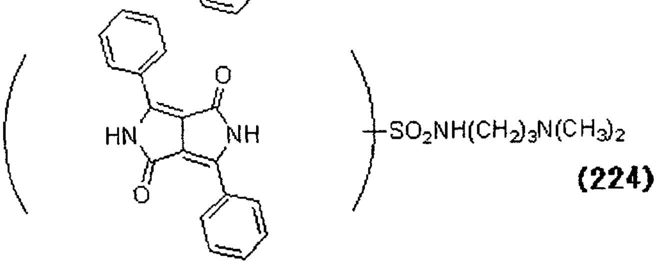

(224)

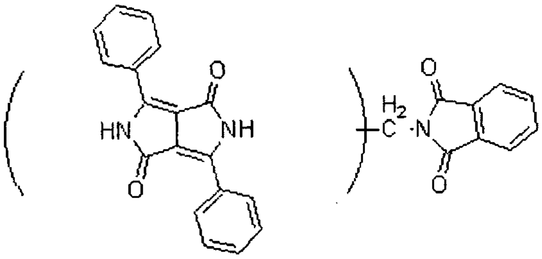

(225)

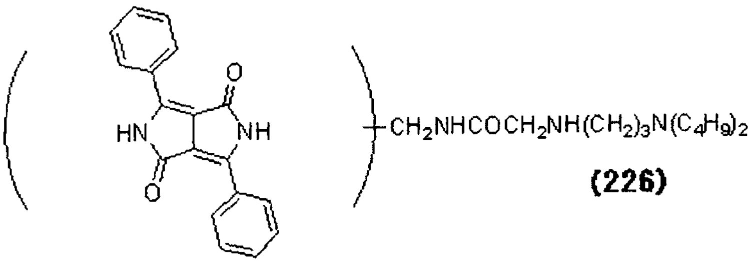

(226)

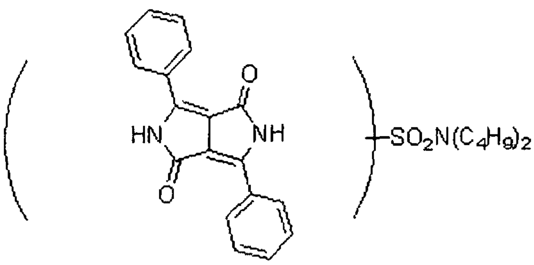

(227)

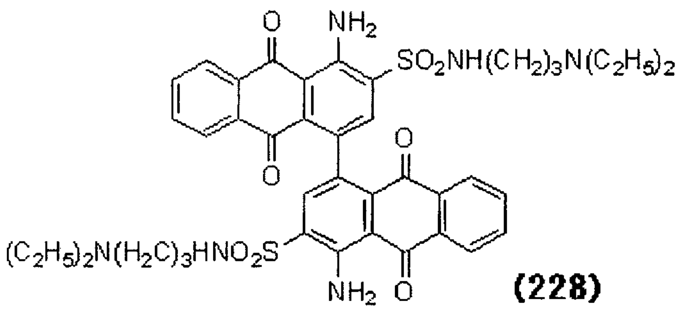

(228)

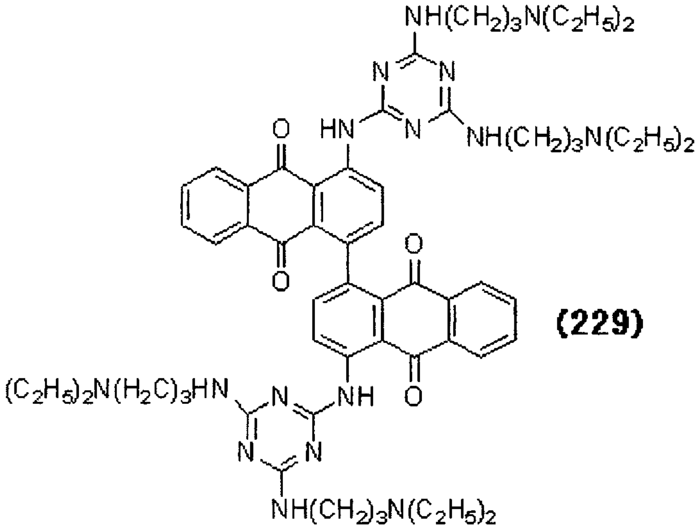

(229)

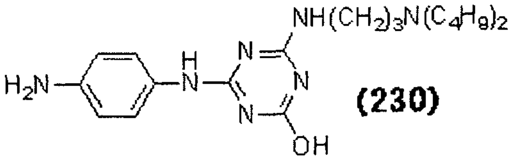

(230)

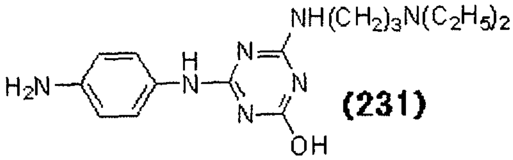

(231)

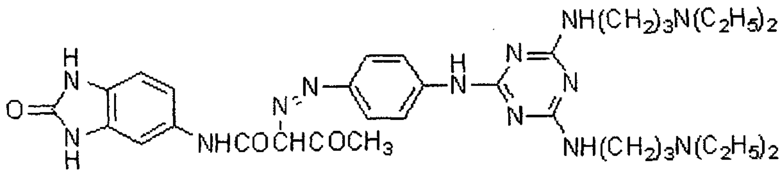

(232)

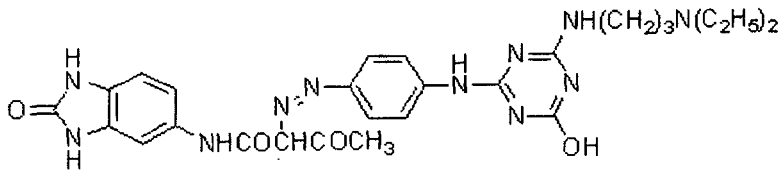

(233)

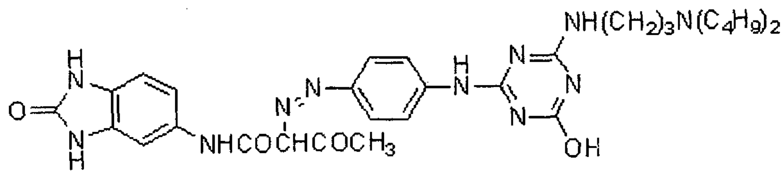

(234)

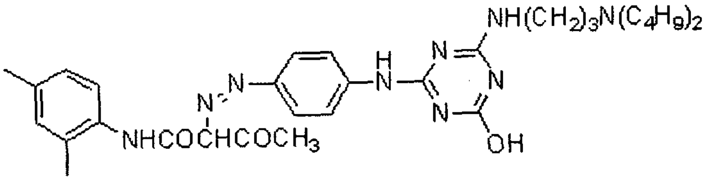

(235)

(236)

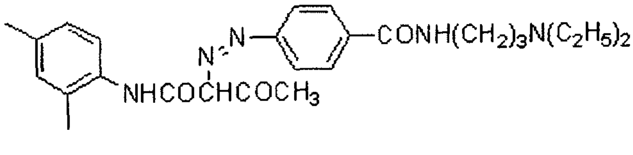

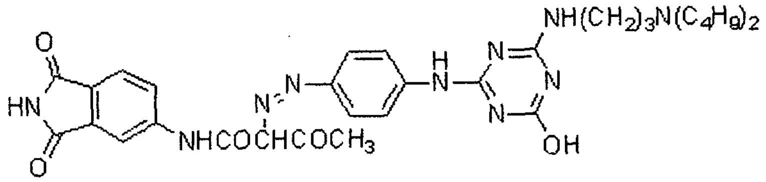

(237)

When these pigment derivatives are used, there are obtained a pigment composition and a coloring composition for color filter, which have satisfactory dispersibility and exhibit high contrast when formed into films, similarly to the case of using an anthraquinone derivative. The compositions and production methods for pigment compositions and coloring compositions that make use of these pigment derivatives are the same as the composition and production method for a pigment composition and a coloring composition that make use of an anthraquinone derivative, which composition and production method may be directly applied.

The form of the C.I. Pigment Red 177 used in the pigment composition of the present invention is not particularly limited, but it is most convenient to dissolve a commercially available C.I. Pigment Red 177 in sulfuric acid. It is also acceptable to use the reaction mixture obtained from the synthesis of the C.I. Pigment Red 177 directly, without separating and purifying the C.I. Pigment Red 177.

The C.I. Pigment Red 177 can be synthesized by a known method. For example, 1-amino-4-bromo-anthraquinone-2-sulfonic acid is heated together with a copper powder or a copper compound in an acidic medium, to thereby synthesize 4,4'-diamino-1,1'-dianthraquinonyl-3,3'-disulfonic acid. Subsequently, the product is desulfonated by heating in an 80 wt% to 90 wt% sulfuric acid at 120 to 220°C, and thus C.I. Pigment Red 177 can be obtained. A synthesis example according to this method is disclosed in JP-B No. 38-25842. According to the present invention, the sulfuric acid solution of C.I. Pigment Red 177 thus synthesized may be used directly. In that case, the pigment derivative may be added at any stage. However, as for the anthraquinone derivative that is susceptible to hydrolysis under acidic conditions, the reaction mixture obtained after the completion of reaction is preferably added after being cooled to 30°C or below.

The method for preparing a sulfuric acid solution containing the C.I. Pigment Red 177 and the pigment derivative is not particularly limited. Respective powders of the compounds may be added and dissolved in sulfuric acid, or each powder may be dissolved in sulfuric acid, and then the respective sulfuric acid solutions may be mixed. There is no limitation on the order of addition or the like at the time of adding the respective powders in sulfuric acid.

The concentration of this sulfuric acid is not particularly limited as long as it is a concentration capable of dissolving the respective raw materials and does not generate a reaction such as sulfonation, but the concentration is preferably 70 wt% to 98 wt%. When the concentration is less than 70 wt%, the solubility of the C.I. Pigment Red 177 is low, and the amount of sulfuric acid required per unit amount of the C.I. Pigment Red 177 to be dissolved increases, so that productivity is lowered. Furthermore, if the concentration exceeds 98 wt%, there is a possibility that the C.I. Pigment Red 177 or the pigment derivative undergoes sulfonation even at low temperature, which is not preferable.

The amount of this sulfuric acid needs to be increased or decreased depending on the concentration of sulfuric acid, but the amount is not particularly limited as long as it is an amount capable of dissolving the compounds completely. For example, when a 98 wt% sulfuric acid is to be used, the sulfuric acid is used preferably in an amount 3- to 100-fold, and more preferably 5- to 30-fold, the total weight of the C.I. Pigment Red 177 and the pigment derivative. If the amount of sulfuric acid is smaller than this range, it may be difficult to completely dissolve the C.I. Pigment Red 177 and the pigment derivative at low temperature. Even if the amount is larger than this range, there is no merit to the product quality, and it is not economical because productivity is lowered.

The temperature at which the C.I. Pigment Red 177 and the pigment derivative are dissolved in sulfuric acid, is not particularly limited as long as the temperature is in the range that does not cause degradation of the raw materials or does not induce a reaction such as sulfonation. However, for example, when a 98 wt% sulfuric acid is used, the temperature is preferably from 3°C to 60°C, and more preferably from 3°C to 40°C. If the temperature is below 3°C, sulfuric acid undergoes congelation, and it becomes difficult to stir the solution uniformly, which is not preferable. Furthermore, if dissolution is carried out at a higher temperature than the aforementioned temperatures, there is a possibility that the C.I. Pigment Red 177 or the pigment derivative is sulfonated or degraded.

According to the present invention, the temperature at which the sulfuric acid solution of the C.I. Pigment Red 177 and the pigment derivative is precipitated by mixing with water, is not particularly limited. The temperature may vary depending on the type of the pigment derivative used, but since in many cases, particles tend to become finer at lower temperature compared to the instance where particles are precipitated at high temperature, it is preferable to carry out the precipitation at a temperature from 0°C to 60°C. As for the water used in that case, use can be made of all kinds that can be used industrially, such as tap water, well water and warm water. However, in order to reduce temperature increases during precipitation, it is preferable to use water that has been previously cooled.

The method of mixing the sulfuric acid solution and water is not particularly limited, and the mixing may be

carried out by any method as long as the C.I. Pigment Red 177 and the pigment derivative can be completely precipitated. For example, precipitation can be carried out by a method of injecting the sulfuric acid solution to a previously prepared ice water, or a method of continuously injecting the sulfuric acid into flowing water using an apparatus such as an aspirator.

The slurry obtained by the methods shown above is filtered and washed to remove acidic components, and then the residue is dried and pulverized. Therefore, the pigment composition of the present invention can be obtained. When the slurry is filtered, the slurry obtained by mixing a sulfuric acid solution and water may be filtered directly, but if the filterability of the slurry is poor, the slurry may be heated and stirred before filtration. Furthermore, when a pigment derivative having a basic substituent is used, there is a possibility that the pigment derivative obtained after precipitation is in the form of a sulfuric acid salt, and in that case, it is preferable to filter the slurry after neutralizing the slurry.

According to the present invention, the content of the pigment derivative is preferably in the range of 0.5% by weight to 30% by weight in the total amount of the C.I. Pigment Red 177 and the pigment derivative. When the pigment derivative used in the present invention is used together with the C.I. Pigment Red 177 to produce a pigment composition by the acid pasting method, the pigment derivative has a very high micronizing effect even if a small amount is added. Therefore, a sufficiently fine pigment composition can be prepared if the pigment derivative is added to the pigment composition in an amount of 0.5% by weight. Furthermore, as the content of the pigment derivative increases, the primary particle size of the obtainable pigment composition becomes finer, and thus the contrast of a color filter making use of the pigment composition can be enhanced. However, although the amount of addition of the anthraquinone derivative exceeds 30% by weight of the pigment composition, a conspicuous micronizing effect concomitant with the increase of the amount of addition is not obtained. Furthermore, when the content of the C.I. Pigment Red 177 is decreased, the coloring power decreases, and thus it is not preferable.

The pigment composition of the present invention may also contain a red pigment other than the C.I. Pigment Red 177, an orange pigment or a yellow pigment, in addition to the pigment composition obtained by acid pasting, in order to obtain the desired spectral polarity.

The red pigment or the orange pigment is not particularly limited, and examples thereof include C.I. Pigment Red 7, 14, 41, 48:1, 48:2, 48:3, 48:4, 81:1, 81:2, 81:3, 146, 177, 178, 184, 185, 187, 200, 202, 207, 208, 210, 246, 254, 255, 264, 270 and 272; C.I. Pigment Orange 71 and 73; and the like. Among them, from the viewpoint of the color characteristics and contrast, at least one pigment selected from C.I. Pigment Red 254, 255, 264, 207 and 48:1, C.I. Pigment Orange 71 and 73 is preferred, and C.I. Pigment Red 254 is particularly preferred. These may be used singly, or may be used in combination of two or more kinds.

The yellow pigment is not particularly limited, and examples thereof include C.I. Pigment Yellow 1, 2, 3, 4, 5, 6, 10, 12, 13, 14, 15, 16, 17, 18, 24, 31, 32, 34, 35, 35:1, 36, 36:1, 37, 37:1, 40, 42, 43, 53, 55, 60, 61, 62, 63, 65, 73, 74, 77, 81, 83, 93, 94, 95, 97, 98, 100, 101, 104, 106, 108, 109, 110, 113, 114, 115, 116, 117, 118, 119, 120, 123, 126, 127, 128, 129, 138, 139, 147, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 198, 213 and 214, and the like. Among them, at least one pigment selected from C.I. Pigment Yellow 138, C.I. Pigment Yellow 139, C.I. Pigment Yellow 150, C.I. Pigment Yellow 185, and C.I. Pigment Yellow 13 is preferred, and C.I. Pigment Yellow 150 is particularly preferred. These may be used singly, or may be used in combination of two or more kinds. It is also acceptable to use a yellow pigment and a red pigment other than the C.I. Pigment Red 177 or an orange pigment in combination.

In regard to the red pigment other than C.I. Pigment Red 177, the orange pigment and the yellow pigment, the aforementioned pigments that are generally on the market may be used directly, but the pigments may also be micronized to a desired particle size by methods such as acid pasting, solvent salt milling and dry milling. Among these micronization methods, the acid pasting can be carried out in the same manner as the method for preparing the pigment composition for color filter of the present invention.

When the pigment is micronized by the solvent salt milling method, a mixture containing at least three components of an organic pigment, a water-soluble inorganic salt and a water-soluble solvent is made into a clay-like mixture, and is vigorously kneaded with a kneader or the like. The mixture obtained after kneading is introduced into water, and is stirred with a stirrer into a slurry form. This is filtered, and thereby the water-soluble inorganic salt and the water-soluble solvent are removed. The processes of slurry-making, filtration and washing as described above are repeated, and thus a micronized organic pigment can be obtained.

As the water-soluble inorganic salt, sodium chloride, potassium chloride and the like can be used. These inorganic salts are used in an amount in the range of 1-fold or more, and preferably 20-fold or less, the weight of the organic pigment. If the amount of the inorganic salt is smaller than 1-fold the weight of the organic pigment, it is difficult to sufficiently micronize the pigment. On the other hand, if the amount is larger than 20-fold the weight of the organic pigment, enormous efforts are required to remove the water-soluble inorganic salt and the water-soluble solvent after kneading, and also the amount of pigment that can be treated in one time is decreased. Therefore, this is not preferable in view of productivity.

Since many of the methods for micronization of pigment described above generate heat concurrently with kneading, it is preferable to use a water-soluble solvent having a boiling point of about 120 to 250°C in view of safety.

Examples of the water-soluble solvent are not limited to the following, but include 2-(methoxymethoxy)ethanol, 2-butoxyethanol, 2-(isopentyloxy)ethanol, 2-(hexyloxy)ethanol, ethylene glycol, diethylene glycol, diethylene glycol monomethyl ether, diethylene glycol monoethyl ether, diethylene glycol monobutyl ether, triethylene glycol, triethylene glycol monomethyl ether, liquid polyethylene glycol, 1-methoxy-2-propanol, 1-ethoxy-2-propanol, dipropylene glycol, dipropylene glycol monomethyl ether, dipropylene glycol monoethyl ether, low molecular weight polypropylene glycol, and the like.

In the dry milling method, crude pigment particles are micronized by dry pulverizing them with a pulverizer. In this method, pulverization proceeds through collision or friction between pulverizing media. The apparatus used to carry out dry milling is not particularly limited, but examples include a ball mill and an attriter, which are dry pulverizing apparatuses equipped with pulverizing media such as beads, a vibrating mill and the like. When dry pulverization is performed using these apparatuses, the inside of the pulverizing vessel may be depressurized or may be filled with an inert gas such as nitrogen gas, according to necessity. Furthermore, after performing the dry milling, the above-described solvent salt milling, a stirring treatment in a solvent, or the like may also be carried out.

In the methods for micronization of pigment described above, a single pigment may be used, or two or more kinds of pigments may be used as mixtures. It is also acceptable to use the pigment derivative of the present invention and another pigment derivative in combination. In that case, finer particles can be obtained as compared with the case of carrying out micronization only with the pigment, and a pigment composition with higher quality can be prepared, which is preferable.

The coloring composition for color filter of the present invention containins a pigment composition for color filter and a pigment carrier. The pigment carrier is selected from a transparent resin, a precursor thereof, or a mixture of these. These may be used singly, or may be used as mixtures of two or more kinds. Examples of the precursor include monomers and oligomers that produce transparent resins.

The transparent resin used in the coloring composition for color filter of the present invention preferably has a transmittance of 80% or higher, and particularly preferably 95% or higher, over the entire wavelength region of 400 to 700 nm, which is the visible light region. Examples of the transparent resin include thermoplastic resins, thermosetting resins, active energy ray-curable resins, and the like.

The pigment carrier can be used in an amount of 30 to 700 parts by weight, and preferably 60 to 450 parts by weight, relative to 100 parts by weight of the pigment composition included in the coloring composition. In the case of using a mixture of the transparent resin and a precursor thereof as the pigment carrier, the transparent resin can be used in an amount of 20 to 400 parts by weight, and preferably 50 to 250 parts by weight, relative to 100 parts by weight of the pigment composition included in the coloring composition. The precursor of the transparent resin can be used in an amount of 10 to 300 parts by weight, and preferably 10 to 200 parts by weight, relative to 100 parts by weight of the pigment composition included in the coloring composition.

Among the transparent resins, examples of the thermoplastic resins are not limited to the following examples, but include butyral resins, styrene-maleic acid copolymers, chlorinated polyethylene, chlorinated polypropylene, polyvinyl chloride, vinyl chloride-vinyl acetate copolymers, polyvinyl acetate, polyurethane-based resins, polyester resins, acrylic resins, alkyd resins, polystyrene resins, polyamide resins, rubber-based resins, cyclic rubber-based resins, celluloses, polyethylene (HDPE, LDPE), polybutadiene, polyimide resins, and the like. Examples of the thermosetting resins include, for example, epoxy resins, benzoguanamine resins, rosin-modified maleic acid resins, rosin-modified fumaric acid resins, melamine resins, urea resins, phenolic resins, and the like.

Examples of the active energy ray-curable resin are not limited to the following, but include a resin obtained by reacting a linear polymer having a reactive substituent such as a hydroxyl group, a carboxyl group or an amino group, with a (meth)acrylic compound or cinnamic acid having a reactive substituent such as an isocyanate group, a formyl group or an epoxy group, and introducing a photocrosslinkable group such as a (meth)acryloyl group or a styryl group to the linear polymer; a resin obtained by half-esterifying a linear polymer containing an acid anhydride, such as a styrene-maleic anhydride copolymer or an $\alpha$-olefin-maleic anhydride copolymer, using a (meth)acrylic compound having a hydroxyl group, such as hydroxyalkyl (meth)acrylate; and the like.

Examples of the monomer and oligomer which are precursors of the transparent resin, are not limited to the following, but include acrylic acid esters and methacrylic acid esters such as methyl (meth)acrylate, ethyl (meth)acrylate, 2-hydroxyethyl (meth)acrylate, 2-hydroxypropyl (meth)acrylate, cyclohexyl (meth)acrylate, $\beta$-carboxyethyl (meth)acrylate, polyethylene glycol di(meth)acrylate, 1,6-hexanediol di(meth)acrylate, triethylene glycol di(meth)acrylate, tripropylene glycol di(meth)acrylate, trimethylolpropane tri(meth)acrylate, pentaerythritol tri(meth)acrylate, 1,6-hexanediol diglycidiyl ether di(meth)acrylate, bisphenol A diglycidyl ether di(meth)acrylate, neopentyl glycol diglycidyl ether di(meth) acrylate, dipentaerythritol hexa(meth)acrylate, tricyclodecanyl (meth) acrylate, ester acrylate, (meth) acrylic acid ester of methylolated melamine, epoxy (meth) acrylate, and urethane acrylate; (meth) acrylic acid, styrene, vinyl acetate, hydroxyethyl vinyl ether, ethylene glycol divinyl ether, pentaerythritol trivinyl ether, (meth)acrylamide, N-hydroxymethyl (meth)acrylamide, N-vinylformamide, acrylonitrile, and the like. These may be used singly or may be used as mixtures of two or more kinds.

It is preferable that the method for manufacturing the coloring composition of the present invention further

include adding a mixture of a pigment dispersant, an organic solvent and a resin (varnish). Furthermore, if necessary, the coloring composition may also include various additives, a resin type dispersant, and the like.
Upon the preparation of a pigment dispersion, the pigment and the pigment dispersant may be added as a pigment composition that has been obtained by mixing in advance, or may be added separately and then dispersed. The order of addition or method of addition for the respective raw materials is not particularly limited. The coloring composition can be prepared by dispersing the components with a dispersing machine.

The pigment dispersant is not limited to the following, but there may be mentioned a pigment derivative having a basic substituent, or a pigment derivative having a similar substituent. The linking group for linking a basic functional group to the pigment is not particularly limited.

In regard to the pigment derivative, it is preferable to use a derivative that does not exert adverse effects on the color of the coloring composition, and derivatives of a red pigment, an orange pigment or a yellow pigment are preferred. As for the pigment that may be used to prepare a pigment derivative, those pigments exemplified as pigments that can be used together with the pigment composition of the present invention may be mentioned. Furthermore, it is not necessary for the pigment derivative to have exactly the same structure as that of the pigment, and even a derivative having a portion of the structure of the pigment has a sufficient dispersing effect, and thus can be suitably used.

Among these, since the dispersing effect of a pigment dispersant having the same chemical structure or a portion of the structure as that of the pigment included in the pigment composition is particularly high, it is preferable to use such a pigment dispersant. Since the method for manufacturing the pigment composition of the present invention contains C.I. Pigment Red 177, which is a dianthraquinone pigment, as an essential component, it is particularly preferable to use an anthraquinone derivative or a dianthraquinone derivative, each having a basic substituent.

In regard to the pigment dispersant, a dispersant having a specific structure may be used singly, and when plural pigments are included in the pigment composition, plural dispersants having the optimal structures for the respective pigments may be used in combination. The amount of use of the pigment dispersant is preferably 0.1 parts by weight to 40 parts by weight, and particularly preferably 1 part by weight to 20 parts by weight, relative to 100 parts by weight of the pigment composition of the present invention.

The organic solvent is not particularly limited, but all that are commonly used as solvents can be put to use. Examples of such an organic solvent include cyclohexanone, ethylcellosolve acetate, butylcellosolve acetate, propylene glycol monomethyl ether acetate, diethylene glycol dimethyl ether, ethylbenzene, ethylene glycol diethyl ether, toluene, xylene, ethylcellosolve, methyl n-amyl ketone, propylene glycol monomethyl ether, toluene, methyl ethyl ketone, methyl isobutyl ketone, ethyl acetate, butyl acetate, n-hexane, methanol, ethanol, isopropyl alcohol, butanol, dioxane, dimethylformamide, Solvesso 100 (manufactured by Exxon Mobile Corp.), Swasol 1000 (manufactured by Cosmo Matsuyama Oil Co., Ltd.), petroleum-based solvents, and the like. These can be used singly or as mixtures.

The organic solvent can be used in an amount of 20 to 5000 parts by weight relative to 100 parts by weight of the pigment composition of the present invention.

The dispersing machine that is used to prepare the coloring composition (pigment dispersion) is not particularly limited, but for example, a horizontal type sand mill, a vertical type sand mill, an annular type bead mill, an attriter, a microfluidizer, a high speed mixer, a homomixer, a ball mill, a roll mill, a millstone type mill, an ultrasonic dispersing machine, a paint conditioner and the like may be mentioned. Thus, use can be made of all types of dispersing machines or mixing machines that are commonly used to prepare a dispersion.

Prior to performing dispersion using such a dispersing machine, a treatment such as pre-dispersion using a kneader mixer such as a kneader or a three-roll mill, or solid dispersion by a two-roll mill, may also be carried out. Furthermore, a process for performing a post-treatment of dispersing with a dispersing machine and then storing for about several hours to one week in a warmed state at 30 to 80°C, or performing a post-treatment using an ultrasonic dispersing machine, a collision type beadless dispersing machine or the like, is effective for imparting dispersion stability to a pigment dispersion.

The method for manufacturing a coloring composition of the present invention is used for the production of a color filter.

The color filter is equipped with filter segments and a black matrix on a substrate, and can include, for example, a black matrix and filter segments of 2 to 6 colors selected from red, green, blue, yellow, cyan and magenta colors. The filter segments and/or black matrix are formed on a substrate by applying the coloring composition of the present invention by a spin coat method or a die coat method.

EXAMPLES

Hereinafter, the present invention will be explained in more detail by way of Examples, but the present invention is not intended to be limited to these.

Production Example 1 <Preparation of pigment composition A>

While 5 kg of a 98% sulfuric acid weighed in a stirring vessel is stirred at room temperature, as shown in Table 1, 460 g of C.I. Pigment Red 177 ("Cromophtal Red A2B" manufactured by Ciba Specialty Chemicals Corp.) and 40 g of the anthraquinone derivative A indicated in Table 2 were slowly added, and the mixture was stirred for one hour still at room temperature to completely dissolve. Thus, a sulfuric acid solution was obtained. In another stirring vessel, 25 kg of water and 25 kg of ice were mixed, and while the mixture was stirred, the above-described sulfuric acid solution was slowly injected therein, to thereby obtain a slurry. The liquid temperature of the slurry after the injection was 8°C. The obtained slurry was filtered and washed with water until the pH of the filtrate reached 7 or higher. This resultant was dried and pulverized, and thus 465 g of a pigment composition A was obtained.

Production Example 2 <Preparation of pigment composition B>

While 5 kg of a 98% sulfuric acid weighed in a stirring vessel is stirred at room temperature, as shown in Table 1, 460 g of C.I. Pigment Red 177 ("Cromophtal Red A2B" manufactured by Ciba Specialty Chemicals Corp.) and 40 g of the anthraquinone derivative B indicated in Table 2 were slowly added, and the mixture was stirred for one hour still at room temperature to completely dissolve. Thus, a sulfuric acid solution was obtained. The sulfuric acid solution was suctioned into an aspirator in which water at 5°C was passed to flow at a water pressure of 3.5 $kg/cm^2$, to thereby precipitate a pigment composition, and thus a slurry was obtained. The liquid temperature of the slurry was 50°C. Sodium hydroxide was added to the slurry, and the pH was adjusted to 11. The slurry was stirred for one hour at 80°C. This slurry was filtered and washed with water until the pH of the filtrate reached 9 or lower. The resultant was then dried and pulverized, and thus 460 g of a pigment composition B was obtained.

Production Examples 3 to 7 <Preparation of pigment compositions C to G>

Pigment compositions C to G were prepared in the same manner as in Production Example 1, except that the anthraquinone derivative A used in the Production Example 1 was changed to anthraquinone derivatives C to G indicated in Table 2, and the mixing amount was changed as indicated in Table 1.

Production Examples 8 to 12 <Preparation of pigment composition H to L>

Pigment compositions H to L were prepared in the same manner as in Production Example 2, except that the anthraquinone derivative B used in the Production Example 2 was changed to anthraquinone derivatives H to L indicated in Table 3, and the mixing amount was changed as indicated in Table 1.

Production Example 13 <Preparation of pigment composition M>

A pigment composition M was prepared in the same manner as in Production Example 2, except that the amount of the C.I. Pigment Red 177 ("Cromophtal Red A2B" manufactured by Ciba Specialty Chemicals Corp.) used in Production Example 2 was changed to 495 g, and the amount of the anthraquinone derivative B was changed to 5 g.

Production Example 14 <Preparation of pigment composition N>

A pigment composition N was prepared in the same manner as in Production Example 2, except that the amount of the C.I. Pigment Red 177 ("Cromophtal Red A2B" manufactured by Ciba Specialty Chemicals Corp.) used in Production Example 2 was changed to 400 g, and the amount of the anthraquinone derivative B was changed to 100 g.

Production Example 15 <Preparation of pigment composition O>

A pigment composition O was prepared in the same manner as in Production Example 2, except that the amount of the C.I. Pigment Red 177 ("Cromophtal Red A2B" manufactured by Ciba Specialty Chemicals Corp.) used in Production Example 2 was changed to 498.5 g, and the amount of the anthraquinone derivative B was changed to 1.5 g.

Production Example 16 <Preparation of pigment composition P>

A pigment composition P was prepared in the same manner as in Production Example 2, except that the amount of the C.I. Pigment Red 177 ("Cromophtal Red A2B" manufactured by Ciba Specialty Chemicals Corp.) used in Production Example 2 was changed to 300 g, and the amount of the anthraquinone derivative B was changed to 200 g.

Production Example 17 <Preparation of pigment composition Q>

A pigment composition Q was prepared in the same manner as in Production Example 2, except that the anthraquinone derivative B used in Production Example 2 was changed to anthraquinone derivative Y indicated in Table 4.

Production Example 18 <Preparation of pigment composition R>

A red treated pigment R was prepared in the same manner as in Production Example 2, except that the anthraquinone derivative B used in Production Example 2 was changed to pigment derivative Z indicated in Table 4.

Production Example 19 <Preparation of pigment composition S>

A mixture of 276 g of C.I. Pigment Red 177 ("Cromophtal Red A2B" manufactured by Ciba Specialty Chemicals Corp.), 24 g of anthraquinone derivative B, 1500 g of sodium chloride and 250 g of diethylene glycol was kneaded for 6 hours at 60°C using a 1-gallon kneader made of stainless steel (manufactured by Inoue Manufacturing Co., Ltd.). Subsequently, this kneaded product was introduced into 15 liters of warm water, and the mixture was stirred for one hour while the mixture was heated at 70°C, to thereby make the kneaded product into a slurry form. The slurry was repeatedly filtered and washed with water to remove sodium chloride and diethylene glycol, and then the residue was dried and pulverized to obtain 290 g of a pigment composition S.

Production Example 20 <Preparation of red treated pigment A>

A mixture of 300 g of a diketopyrrolopyrrole-based red pigment, C.I. Pigment Red 254 ("Irgaphor Red B-CF" manufactured by Ciba Specialty Chemicals Corp.), 1500 g of sodium chloride and 150 g of diethylene glycol was kneaded for 6 hours at 60°C using a 1-gallon kneader made of stainless steel (manufactured by Inoue Manufacturing Co., Ltd.). Subsequently, this kneaded product was introduced into 15 liters of warm water, and the mixture was stirred for one hour while the mixture was heated at 70°C, to thereby make the kneaded product into a slurry form. The slurry was repeatedly filtered and washed with water to remove sodium chloride and diethylene glycol, and then the residue was dried and pulverized to obtain 290 g of an red-colored treated pigment A.

Production Examples 21 to 26 <Pigment compositions T to Y>

Pigment compositions T to Y were prepared in the same manner as in Production Example 2, except that the anthraquinone derivative B used in Production Example 2 was changed to pigment derivatives M to R indicated in Table 5.

Production Examples 27 to 28 <Pigment compositions Z to AA>

Pigment compositions Z to AA were prepared in the same manner as in Production Example 1, except that the anthraquinone derivative A used in Production Example 1 was changed to pigment derivatives S to T indicated in Table 6.

Production Example 29 <Pigment composition AB>

A pigment composition AB was adjusted in the same manner as in Production Example 1, except that 40 g of the anthraquinone derivative A used in Production Example 1 was changed to 20 g of the anthraquinone derivative B indicated in Table 2 and 20 g of pigment derivative T indicated in Table 6.

Production Example 30 <Pigment Composition AC>

A pigment composition AC was adjusted in the same manner as in Production Example 1, except that 40 g of the anthraquinone derivative A used in Production Example 1 was changed to 30 g of pigment derivative S and 10 g of pigment derivative T indicated in Table 6.

Table 1

| Production Example | <Preparation of Composition> | C.I.pigment red 177 Amount(g) | Anthraquinone derivative or Pigment derivative | |
|---|---|---|---|---|
| | | | Kind | Amount (g) |
| 1 | Composition A | 460 | A | 40 |
| 2 | Composition B | 460 | B | 40 |
| 3 | Composition C | 465 | C | 35 |
| 4 | Composition D | 425 | D | 75 |
| 5 | Composition E | 480 | E | 20 |
| 6 | Composition F | 475 | F | 25 |
| 7 | Composition G | 460 | G | 40 |
| 8 | Composition H | 470 | H | 30 |
| 9 | Composition I | 440 | I | 60 |
| 10 | Composition J | 460 | J | 40 |
| 11 | Composition K | 455 | K | 45 |
| 12 | Composition L | 450 | L | 50 |
| 13 | Composition M | 495 | B | 5 |
| 14 | Composition N | 400 | B | 100 |
| 15 | Composition O | 498.5 | B | 1.5 |
| 16 | Composition P | 300 | B | 200 |
| 17 | Composition Q | 460 | Y | 40 |
| 18 | Composition R | 460 | Z | 40 |
| 19 | Composition S | 276 | B | 24 |
| 20 | Red treated composition A | 300 (C.I.pigment red 254) | - | - |
| 21 | Composition T | 460 | M | 40 |
| 22 | Composition U | 460 | N | 50 |
| 23 | Composition V | 460 | O | 40 |
| 24 | Composition W | 460 | P | 50 |
| 25 | Composition X | 460 | Q | 50 |
| 26 | Composition Y | 460 | R | 50 |
| 27 | Composition Z | 460 | S | 50 |
| 28 | Composition AA | 460 | T | 40 |
| 29 | Composition AB | 460 | B/T | 20/20 |
| 30 | Composition AC | 460 | SIT | 30/10 |

Table 2

| | |
|---|---|
| Anthraquinone derivative A | 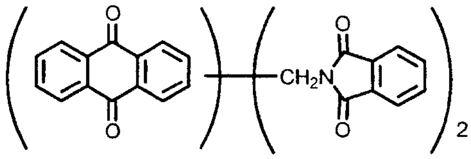 |
| Anthraquinone derivative B | 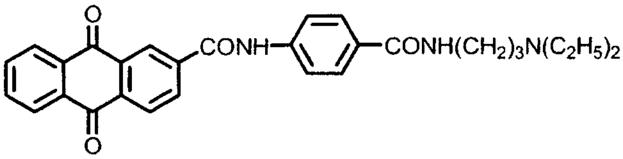 |
| Anthraquinone derivative C | 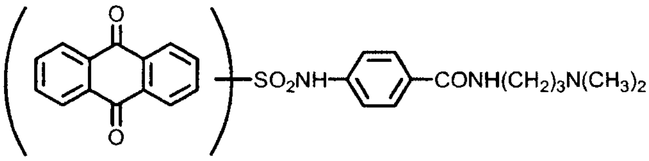 |
| Anthraquinone derivative D | 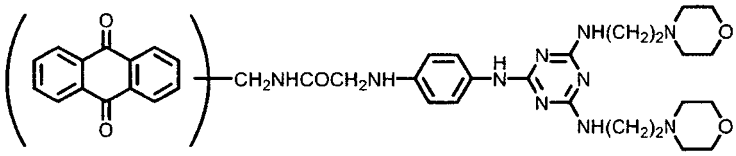 |
| Anthraquinone derivative E | 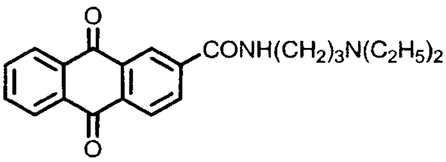 |
| Anthraquinone derivative F | 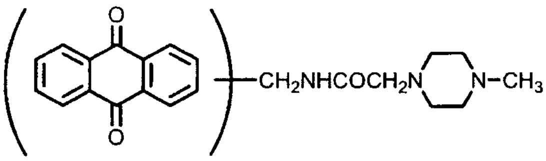 |
| Anthraquinone derivative G | 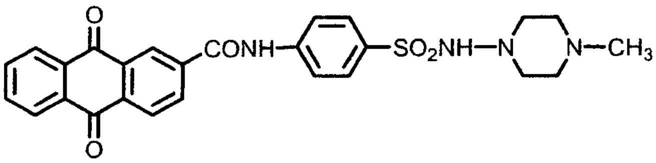 |

Table3

| | |
|---|---|
| Anthraquinone derivative H | 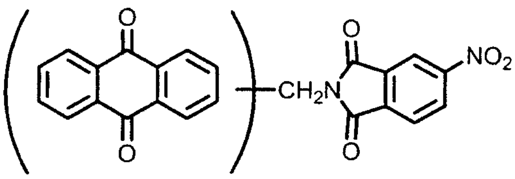 |

(continued)

| | |
|---|---|
| Anthraquinone derivative I | 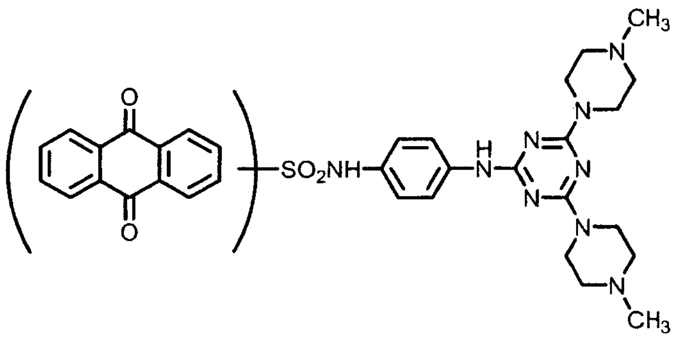 |
| Anthraquinone derivative J | 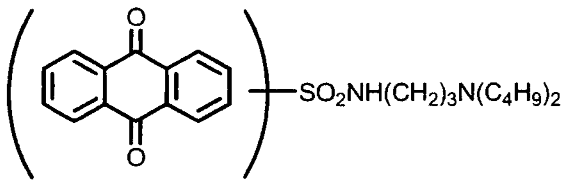 |
| Anthraquinone derivative K | 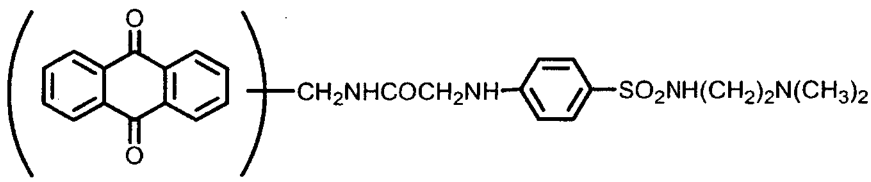 |
| Anthraquinone derivative L | 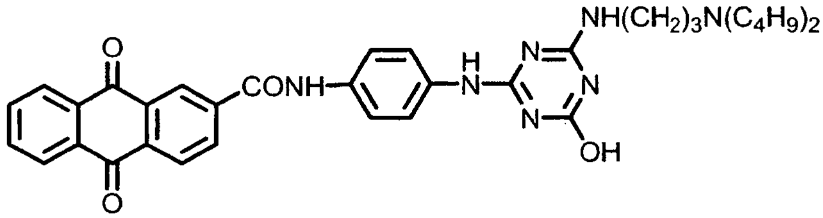 |

Table 4

| | |
|---|---|
| Anthraquinone derivative Y | 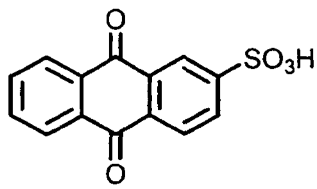 |
| Pigment derivative Z (which is not comprised by the present invention) | 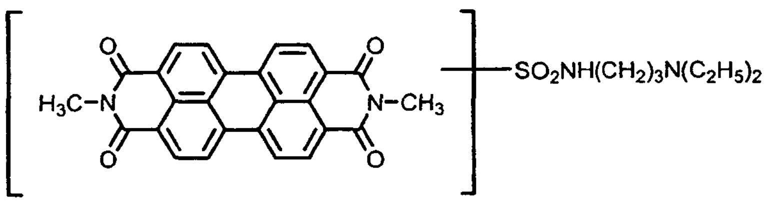 |

Table 5

| | |
|---|---|
| Pigment derivative M | 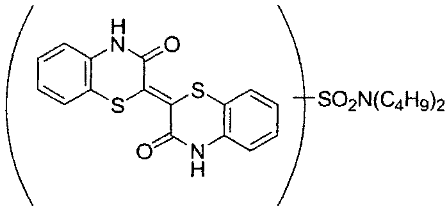 |
| Pigment derivative N | 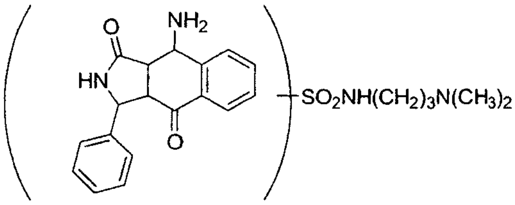 |
| Pigment derivative O | 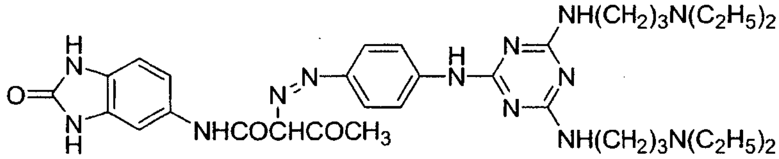 |
| Pigment derivative P | 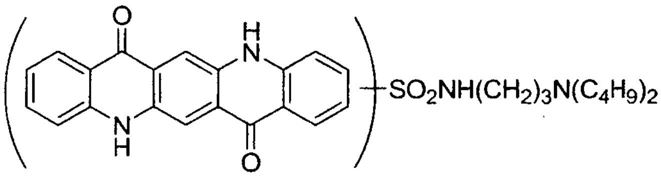 |
| Pigment derivative Q | 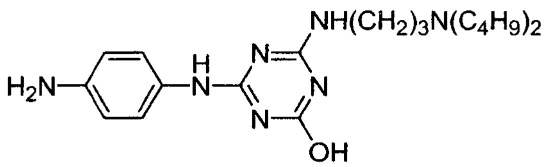 |
| Pigment derivative R | 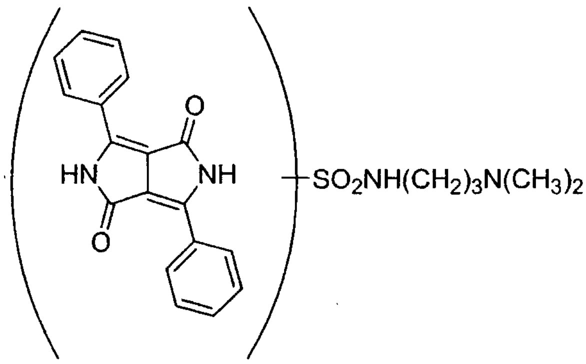 |

Table 6

| | |
|---|---|
| Pigment derivative S | 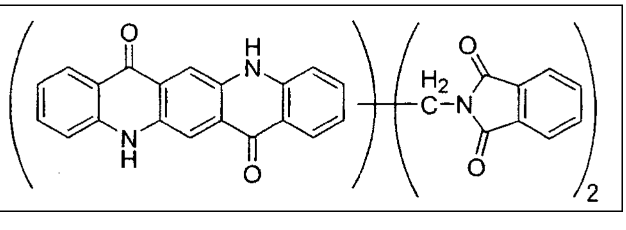 |

(continued)

| | |
|---|---|
| Pigment derivative T | 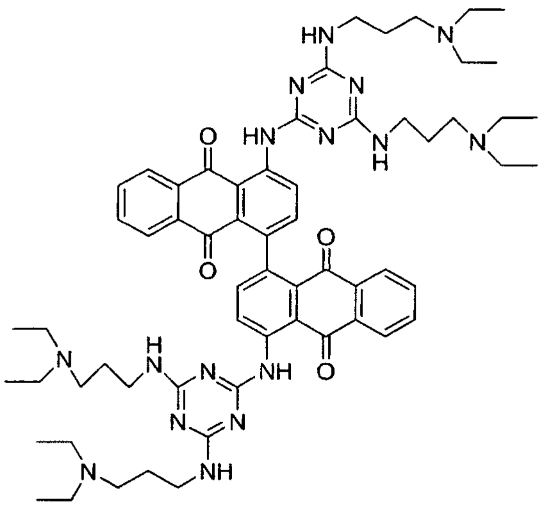 |

(Preparation of acrylic resin solution)

700 g of cyclohexanone was added to a separable four-necked flask equipped with a thermometer, a cooling tube, a nitrogen gas inlet tube and a stirring apparatus, and the compound was heated to 80°C. The reaction vessel was purged with nitrogen, and then a mixture of 133 g of n-butyl methacrylate, 46 g of 2-hydroxyethyl methacrylate, 43 g of methacrylic acid, 74 g of paracumylphenol ethylene oxide-modified acrylate ("Aronix M110" manufactured by Toagosei Co., Ltd.), and 4.0 g of 2,2'-azobisisobutyronitrile was added dropwise from a dropping tube into the flask over 2 hours. After completion of the dropwise addition, the reaction was further continued for 3 hours, and thus a solution of an acrylic resin having a weight average molecular weight of 26000 was obtained.

The solution was cooled to room temperature, and about 2 g of the resin solution was heated at 180°C for 20 minutes for drying. Then, an involatile fraction was measured. Cyclohexanone was added to adjust the involatile fraction of the resin solution to 20%, and thus an acrylic resin solution was obtained.

(Examples 1 to 38, and Comparative Examples 1 to 4)

The pigment or pigment composition, the pigment dispersants A to C indicated in Table 7, the acrylic resin solution, and cyclohexanone as a solvent were blended as indicated in Table 8 to 10, and the blend was uniformly stirred and mixed. Subsequently, the mixture was dispersed for 3 hours with an Eiger mill ("Mini Model M-250 MKII" manufactured by Eiger Japan Co., Ltd.), using zirconia beads having a diameter of 1 mm. This product was filtered with a 5-μm filter, and thus a coloring composition was prepared.

Table 7

| | |
|---|---|
| Pigment dispersant A | 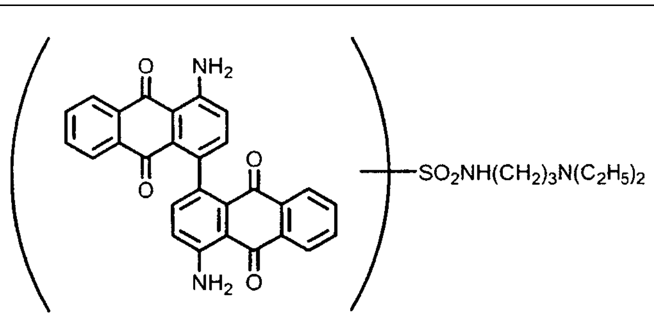 |

(continued)

| | |
|---|---|
| Pigment dispersant B | 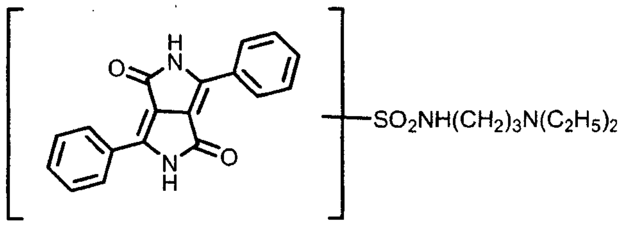 |
| Pigment dispersant C | 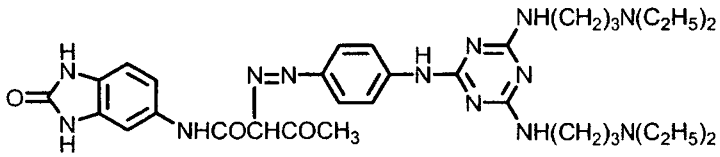 |

(Evaluation of coloring composition)

<Viscosity>

The viscosities at 25°C of the coloring compositions for color filter obtained in Examples 1 to 38 and Comparative Examples 1 to 4 were measured with a cone-plate type viscometer ("TVE-20L type" manufactured by Toki Sangyo Co., Ltd.).

<Production of coated substrate>

Each of the coloring compositions for color filter obtained in Examples 1 to 38 and Comparative Examples 1 to 4 was applied on a glass substrate having a size of 100 mm x 100 mm with a thickness of 1.1 mm using a spin coater, at a speed of rotation of 300 rpm, 500 rpm, 1000 rpm or 1500 rpm, and was dried for 20 minutes at 60°C. Thus, four types of coated substrates having different film thicknesses were obtained.

<Luminosity (Y), chromaticity (x,y)>

The coated substrates produced as described above were subjected to the measurement of luminosity (Y) and chromaticity (x,y) under C-light source with a microspectrophotometer ("OSP-SP100" manufactured by Olympus Corp.).

<Contrast>

The luminances of the coated substrates produced as described above were measured using a luminance colorimeter, BM-5A, manufactured by Topcon Corp. as a luminance meter, and using a polarizing film, LLC2-92-18, manufactured by Sanritsu Corp. as a polarizing plate. Each of the coated substrates was interposed between two sheets of the polarizing plate, and the respective luminances in the case of disposing the polarizing plates in parallel and in the case of disposing the polarizing plates perpendicularly were measured. The ratio of the luminance obtained in the case of disposing the polarizing plates in parallel and the luminance obtained in the case of disposing the polarizing plates perpendicularly was defined as the contrast.

Contrast = (luminance in the case of disposing polarizing plates in parallel)/(luminance in the case of disposing polarizing plates perpendicularly)

Furthermore, upon performing the measurement, the measurement was carried out, with a black mask having

a 1cm x 1cm hole, being superimposed at the measurement portion, for the purpose of shielding unnecessary light.

From the contrast and chromaticity values measured for the 4 sheets of coated substrates produced at different speeds of rotation, a plot of contrast versus x was produced. Each plot was connected by a straight line, and the contrast at x = 0.60 was approximately estimated.

Table 8

| **Example** | Amount | | | | | | Results | |
|---|---|---|---|---|---|---|---|---|
| | Pigment or Pigment composition | | Pigment dispersant | | Acrylic resin solution (g) | Solvent (g) | Viscosity ( mPa •s) | Contrast |
| | Kind | (g) | Kind | (g) | | | | |
| 1 | P-A | 15.0 | A | 1.20 | 50.0 | 60.0 | 52 | 13300 |
| 2 | P-B | 15.0 | A | 1.20 | 50.0 | 60.0 | 30 | 15200 |
| 3 | P-C | 15.0 | A | 1.20 | 50.0 | 60.0 | 35 | 14300 |
| 4 | P-D | 15.0 | A | 1.20 | 50.0 | 60.0 | 38 | 13800 |
| 5 | P-E | 15.0 | A | 1.20 | 50.0 | 60.0 | 32 | 14900 |
| 6 | P-F | 15.0 | A | 1.20 | 50.0 | 60.0 | 42 | 13500 |
| 7 | P-G | 15.0 | A | 1.20 | 50.0 | 60.0 | 34 | 14500 |
| 8 | P-H | 15.0 | A | 1.20 | 50.0 | 60.0 | 48 | 12800 |
| 9 | P-I | 15.0 | A | 1.20 | 50.0 | 60.0 | 37 | 13700 |
| 10 | P-J | 15.0 | A | 1.20 | 50.0 | 60.0 | 33 | 14000 |
| 11 | P-K | 15.0 | A | 1.20 | 50.0 | 60.0 | 43 | 13700 |
| 12 | P-L | 15.0 | A | 1.20 | 50.0 | 60.0 | 28 | 15100 |
| 13 | P-M | 15.0 | A | 1.20 | 50.0 | 60.0 | 33 | 13800 |
| 14 | P-N | 15.0 | A | 1.20 | 50.0 | 60.0 | 37 | 15800 |
| 15 | P-B | 15.0 | A | 1.20 | 30.0 | 80.0 | 45 | 12300 |
| 16 | P-B | 15.0 | A | 1.20 | 110 | 0.0 | 68 | 13300 |
| 17 | P-B | 15.0 | A | 1.20 | 50.0 | 0.0 | 120 | 12400 |
| 18 | P-B | 15.0 | A | 1.20 | 50.0 | 430 | 4.1 | 12000 |
| 19 | P-B | 15.0 | A | 0.30 | 50.0 | 60.9 | 72 | 12200 |
| 20 | P-B | 15.0 | A | 3.00 | 50.0 | 58.2 | 55 | 12500 |
| 21 | P-B | 9.00 | A | 0.72 | 50.0 | 60.0 | 54 | 10200 |
| | R-A | 6.00 | B | 0.48 | | | | |

Table 9

| Example | Amount | | | | | | Results | |
|---|---|---|---|---|---|---|---|---|
| | Pigment or Pigment composition | | Pigment dispersant | | Acrylic resin solution (g) | Solvent (g) | Viscosity ( mPa • s) | Contrast |
| | Kind | (g) | Kind | (g) | | | | |
| 20 | P-B | 15.0 | A | 3.00 | 50.0 | 58.2 | 55 | 12500 |
| 21 | P-B | 9.00 | A | 0.72 | 50.0 | 60.0 | 54 | 10200 |
| | R-A | 6.00 | B | 0.48 | | | | |

(continued)

| Example | Amount | | | | | | Results | |
|---|---|---|---|---|---|---|---|---|
| | Pigment or Pigment composition | | Pigment dispersant | | Acrylic resin solution (g) | Solvent (g) | Viscosity ( mPa • s) | Contrast |
| | Kind | (g) | Kind | (g) | | | | |
| 22 | P-B | 9.00 | A | 0.72 | 50.0 | 60.0 | 48 | 11500 |
| | R-A | 3.00 | B | 0.24 | | | | |
| | Y-A | 3.00 | C | 0.24 | | | | |
| 23 | P-T | 15.0 | A | 1.20 | 50.0 | 60.0 | 41 | 13600 |
| 24 | P-U | 15.0 | A | 1.20 | 50.0 | 60.0 | 32 | 14500 |
| 25 | P-V | 15.0 | A | 1.20 | 50.0 | 60.0 | 47 | 14300 |
| 26 | P-W | 15.0 | A | 1.20 | 50.0 | 60.0 | 83 | 13800 |
| 27 | P-X | 15.0 | A | 1.20 | 50.0 | 60.0 | 47 | 14200 |
| 28 | P-Y | 15.0 | A | 1.20 | 50.0 | 60.0 | 84 | 13900 |
| 29 | P-Z | 15.0 | A | 1.20 | 50.0 | 60.0 | 102 | 13500 |
| 30 | P-AA | 15.0 | A | 1.20 | 50.0 | 60.0 | 111 | 12600 |
| 31 | P-U | 9.00 | A | 0.72 | 50.0 | 60.0 | 34 | 10200 |
| | R-A | 6.00 | B | 0.48 | | | | |
| 32 | P-Y | 9.00 | A | 0.72 | 50.0 | 60.0 | 102 | 10200 |
| | R-A | 6.00 | B | 0.48 | | | | |
| 33 | P-U | 9.00 | A | 0.72 | 50.0 | 60.0 | 58 | 11500 |
| | R-A | 3.00 | B | 0.24 | | | | |
| | Y-A | 3.00 | C | 0.24 | | | | |
| 34 | P-Y | 9.00 | A | 0.72 | 50.0 | 60.0 | 98 | 11500 |
| | R-A | 3.00 | B | 0.24 | | | | |
| | Y-A | 3.00 | C | | | | | |

Table 10

| **Example** | Amount | | | | | | Results | |
|---|---|---|---|---|---|---|---|---|
| | Pigment or Pigment composition | | Pigment dispersant | | Acrylic resin solution (g) | Solvent (g) | Viscosity (mPa • s) | Contrast |
| | Kind | (g) | Kind | (g) | | | | |
| 35 | P-O | 15.0 | A | 1.20 | 50.0 | 60.0 | 47 | 10800 |
| 36 | P-P | 15.0 | A | 1.20 | 50.0 | 60.0 | 44 | 10500 |
| 37 | P-AB | 15.0 | A | 1.20 | 50.0 | 60.0 | 36 | 13900 |
| 38 | P-AC | 15.0 | A | 1.20 | 50.0 | 60.0 | 34 | 13700 |
| Compartive Example 1 | P-Q | 15.0 | A | 1.20 | 50.0 | 60.0 | 117 | 7300 |
| Compartive Example 2 | P-R | 15.0 | A | 1.20 | 50.0 | 60.0 | 46 | 8000 |

(continued)

| Example | Amount | | | | | | Results | |
|---|---|---|---|---|---|---|---|---|
| | Pigment or Pigment composition | | Pigment dispersant | | Acrylic resin solution (g) | Solvent (g) | Viscosity (mPa • s) | Contrast |
| | Kind | (g) | Kind | (g) | | | | |
| Compartive Example 3 | P-S | 15.0 | A | 1.20 | 50.0 | 60.0 | 35 | 9300 |
| Compartive Example 4 | R-A | 15.0 | B | 1.20 | 50.0 | 60.0 | 167 | 3800 |

P-A: Pigment composition A
P-B: Pigment composition B
P-C: Pigment composition C
P-D: Pigment composition D
P-E: Pigment composition E
P-F: Pigment composition F
P-G: Pigment composition G
P-H: Pigment composition H
P-I: Pigment composition I
P-J: Pigment composition J
P-K: Pigment composition K
P-L: Pigment composition L
P-M: Pigment composition M
P-N: Pigment composition N
P-O: Pigment composition O
P-P: Pigment composition P
P-Q: Pigment composition Q
P-R: Pigment composition R
P-S: Pigment composition S
P-T: Pigment composition T
P-U: Pigment composition U
P-V: Pigment composition V
P-W: Pigment composition W
P-X: Pigment composition X
P-Y: Pigment composition Y
P-Z: Pigment composition Z
P-AA: Pigment composition AA
P-AB: Pigment composition AB
P-AC: Pigment composition AC
R-A: Red treated pigment A
Y-A: Yellow Pigment E4GN-GT
(manufactured by Lanxess AG) [C.I. Pigment Yellow 150]
** The respective symbols for the pigment dispersants are as follows.
A: Pigment dispersant A indicated in Table 7
B: Pigment dispersant B indicated in Table 7
C: Pigment dispersant C indicated in Table 7

As it is obvious from Tables 8 to 10, when the coloring compositions of Examples 1 to 38 in which the C.I. Pigment Red 177 was micronized by an acid pasting method using an anthraquinone derivative represented by the formula (1), was used, low viscosity dispersions could be obtained. Furthermore, these coloring compositions exhibited very high contrast when applied on a substrate. Among them, the coloring compositions of Examples 1 to 34 and 37 to 38 in which the content of the pigment derivative was in a preferred range, exhibited higher contrast as compared with the coloring compositions of Examples 35 to 36.

On the contrary, the coloring compositions of Comparative Examples 1 to 2 which did not use any of the anthraquinone derivative represented by the formula (1) and the specific pigment derivative, exhibited very low contrast.

Furthermore, the coloring composition of Comparative Example 3 in which the pigment was micronized by a salt milling method, exhibited very low contrast. Furthermore, the coloring compositions in which a red pigment other than the C.I. Pigment Red 177 was micronized by a salt milling method, had very high viscosity but exhibited very low contrast.

## Claims

1. A method for manufacturing a pigment composition for color filter, comprising the steps of:

dissolving C.I. Pigment Red 177 and a pigment derivative of the formula of Q-Am having a main structure "Q" selected from the group consisting of the following formulas (1) (i) to (viii) and having a basic or neutral substituent represented by "-Am" in which "A" is selected from a substituted or unsubstituted phthalimidomethyl group, a group represented by the following formula (2), a group represented by the following formula (3) or a group represented by formula H-$X_1$-$X_2$-$X_5$-, and "m" represents an integer from 1 to 8, in sulfuric acid;
subsequently mixing them with water to induce precipitation; and
removing acidic components,

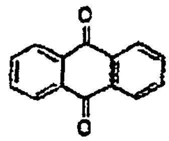
(i)
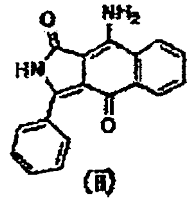
(ii)
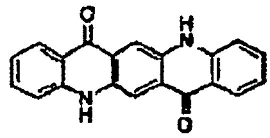
(iii)
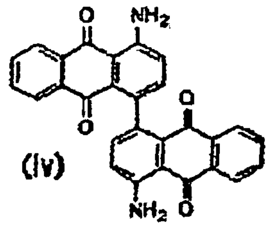
(iv)
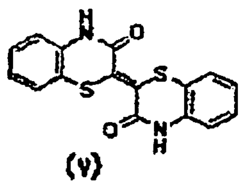
(v)
(vi)
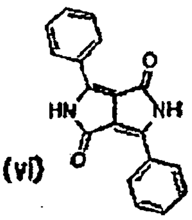
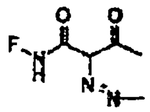
(vii)
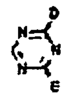
(viii)

Formula (1)

wherein "F" is selected from a phenyl group, a phthalimide group, a benzimidazolone group, a naphthalimide group, and the same groups but having substituents; and "$X_1$", "$X_2$", "$X_5$", "D" and "E" have the same meanings as defined for thefollowing formulas (2) and (3)}:

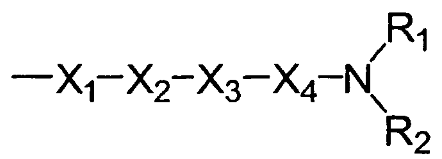
Formula (2)

wherein "$X_1$" is selected from -NH-, a single bond linking between adjacent atoms, $-SO_2-$, -CO-, $-SO_2NR'-$, -CONR'- and $-CH_2NR'COCH_2NR'-$,
"$X_2$" is selected from a single bond linking between adjacent atoms, an alkylene group having 20 or fewer carbon atoms, an alkenylene group having 20 or fewer carbon atoms, an arylene group having 20 or fewer carbon atoms, a heteroaromatic ring having 20 or fewer carbon atoms, and the same groups but having substituents

(these groups may be linked to each other via a divalent linking group selected from -NR'-, -O-, -$SO_2$-or -CO-),
"$X_3$" is selected from a single bond linking between adjacent atoms, -$SO_2$NR'- and -CONR'-,
"$X_4$" is selected from a single bond linking between adjacent atoms, an alkylene group having 20 or fewer carbon atoms, an alkenylene group having 20 or fewer carbon atoms, an arylene group having 20 or fewer carbon atoms, and the same groups but having substituents (these groups may be linked to each other via a divalent linking group selected from -NR'-,- O-, -$SO_2$- or -CO-),
"$R_1$" and "$R_2$" are each independently selected from a hydrogen atom, an alkyl group having 20 or fewer carbon atoms, an alkenyl group having 20 or fewer carbon atoms, and the same groups but having substituents, and $R_1$ and $R_2$ are present singly, are joined to form a ring, or are joined together with a nitrogen atom, an oxygen atom or a sulfur atom to form a heterocycle, and
"R'" is selected from a hydrogen atom, an alkyl group having 20 or fewer carbon atoms, an alkenyl group having 20 or fewer carbon atoms, an aryl group having 20 or fewer carbon atoms, and the same groups but having substituents,

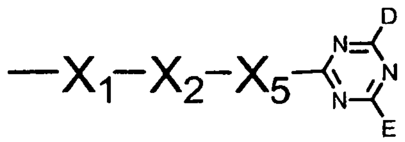

Formula (3)

wherein "$X_1$" and "$X_2$" have the same meaning as defined for the formula (2),
"$X_5$" represents -NR'- or -O-, provided that R' has the same meaning as defined for the formula (2), and
"D" and "E" are each independently selected from a group represented by the following formula (4), a group represented by the following formula (5), a group represented by the following formula (6), -O-$(CH_2)_n$-$R_8$, -$OR_9$, -$NR_{10}R_{11}$. -Cl and -F,
"$R_8$" represents a nitrogen-containing heterocycle residue,
"R", "$R_{10}$" and "$R_{11}$" are each independently selected from a hydrogen atom, an alkyl group having 20 or fewer carbon atoms, an alkenyl group having 20 or fewer carbon atoms, an aryl group having 20 or fewer carbon atoms, and the same groups but having substituents, and
"n" represents an integer from 0 to 20,
provided that any one of D and E is a group represented by the following formula (4) or (5), -O-$(CH_2)_n$-$R_8$, -$OR_9$, or -$NR_{10}R_{11}$,

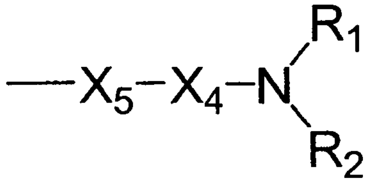

Formula (4)

wherein $X_5$, $X_4$, $R_1$ and $R_2$ have the same meanings as defined for the formula (2) or formula (3),

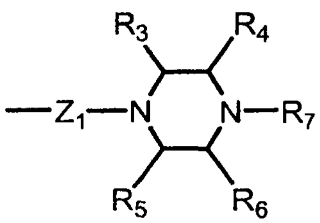

Formula (5)

wherein "$Z_1$" is selected from a single bond linking the triazine ring with a nitrogen atom, -NR'-, -NR'-G-CO-, -NR'-G-CONR"-, -NR'-G-$SO_2$-, -NR'-G-$SO_2$NR"-, -O-G-CO-, -O-G-CONR'-, -O-G-$SO_2$- and -O-G-$SO_2$NR'-,
"G" is selected from an alkylene group having 20 or fewer carbon atoms, an alkenylene group having 20 or fewer carbon atoms, an arylene group having 20 or fewer carbon atoms, and the same groups but having substituents, and
"R'" and "R''" are each independently selected from a hydrogen atom, an alkyl group having 20 or fewer carbon

atoms, an alkenyl group having 20 or fewer carbon atoms, an aryl group having 20 or fewer carbon atoms, and the same groups but having substituents;

$R_3$, $R_4$, $R_5$ and $R_6$ are each independently selected from a hydrogen atom, an alkyl group having 20 or fewer carbon atoms, an alkenyl group having 20 or fewer carbon atoms, an aryl group having 20 or fewer carbon atoms, and the same groups but having substituents; and

"$R_7$" is selected from an alkyl group having 20 or fewer carbon atoms, an alkenyl group having 20 or fewer carbon atoms, and the same groups but having substituents, and

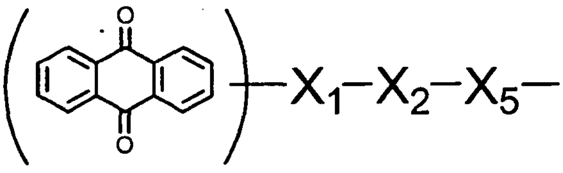

Formula (6)

wherein "$X_1$", "$X_2$" and "$X_5$" have the same meanings as defined for the formula (2) or formula (3).

**2.** The method for manufacturing a pigment composition for color filter according to Claim 1, wherein the pigment derivative is an anthraquinone derivative represented by the following formula (7):

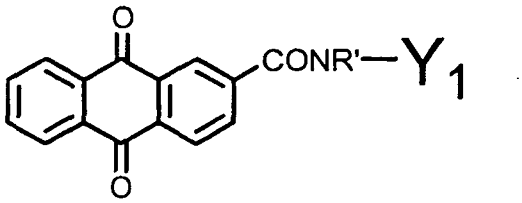

Formula (7)

wherein $Y_1$ represents a group represented by the following formula (8) or the following formula (9):

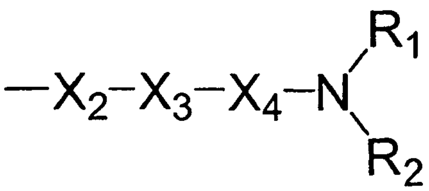

Formula (8)

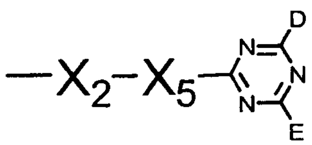

Formula (9)

wherein $X_2$, $X_3$, $X_4$, $X_5$, $R_1$, $R_2$, D and E have the same meanings as defined for the formula (2) or formula (3).

**3.** The method for manufacturing a pigment composition for color filter according to Claim 1 or 2, wherein the content of the pigment derivative is 0.5% by weight to 30% by weight based on the total weight of the C.I. Pigment Red 177 and the pigment derivative.

**4.** The method for manufacturing a pigment composition for color filter, comprising the pigment composition according to any one of claims 1-3, and a red pigment other than the C.I. Pigment Red 177 or an orange pigment.

5. The method for manufacturing a pigment composition for color filter according to claim 4, wherein the red pigment other than the C.I. Pigment Red 177 or the orange pigment is at least one pigment selected from C.I. Pigment Red 254, Pigment Red 255, C.I. Pigment Red 264, C.I. Pigment Red 207, C.I. Pigment Red 48:1, C.I. Pigment Orange 71 and C.I. Pigment Orange 73.

6. A method for manufacturing a pigment composition for color filter, comprising the manufacturing steps of the method for manufacturing a pigment composition according to any one of Claims 1 to 5, and adding a yellow pigment.

7. The method for manufacturing a pigment composition for color filter according to Claim 6, wherein the yellow pigment is at least one pigment selected from C.I. Pigment Yellow 138, C.I. Pigment Yellow 139, C.I. Pigment Yellow 150, C.I. Pigment Yellow 185 and C.I. Pigment Yellow 13.

8. A method for manufacturing a coloring composition for color filter, comprising the manufacturing steps of the method for manufacturing a pigment composition according to any one of Claim 1 to 7, and adding a pigment carrier formed from a transparent resin, a precursor thereof or a mixture of these.

**Patentansprüche**

1. Verfahren zur Herstellung einer Pigment-Zusammensetzung für Farbfilter, welches die Schritte umfaßt, daß man:

- C.I. Pigment Red 177 und ein Pigmentderivat der Formel Q-Am, die eine Hauptstruktur "Q" aufweist, die ausgewählt ist aus der Gruppe, die besteht aus den folgenden Formeln (1) (i) bis (viii) und die einen basischen oder neutralen Substituenten aufweist, der durch "-Am" wiedergegeben wird, worin "A" ausgewählt ist aus einer substituierten oder unsubstituierten Phthalimidomethyl-Gruppe, einer Gruppe, die wiedergegeben wird durch die folgende Formel (2), einer Gruppe, die wiedergegeben wird durch die folgende Formel (3) oder einer Gruppe, die durch die Formel H-$X_1$-$X_2$-$X_5$-wiedergegeben wird, und "m" für eine ganze Zahl von 1 bis 8 steht, in Schwefelsäure auflöst;
- anschließend diese mit Wasser mischt, um eine Präzipitation zu induzieren; und
- saure Bestandteile entfernt;

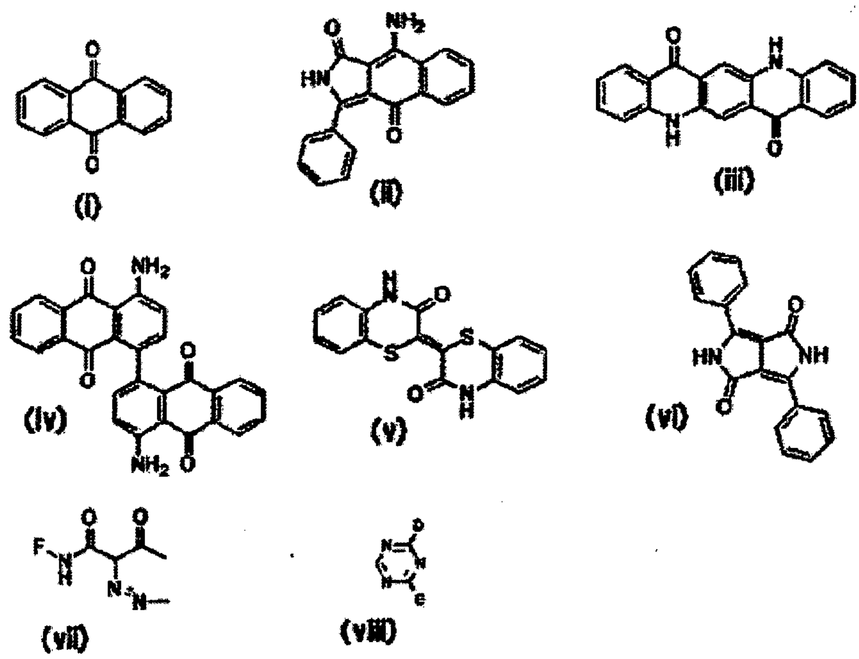
(i) (ii) (iii) (iv) (v) (vi) (vii) (viii)

Formel (1)

worin "F" ausgewählt ist aus einer Phenyl-Gruppe, einer Phthalimid-Gruppe, einer Benzimidazolon-Gruppe, einer Naphthalimid-Gruppe und denselben Gruppen, die jedoch Substituenten aufweisen; und "$X_1$", "$X_2$", "$X_5$", "D" und "E" dieselben Bedeutungen aufweisen, wie sie für die folgenden Formeln (2) und

(3) definiert werden:

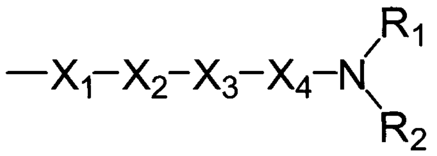

Formel (2)

worin "$X_1$" ausgewählt ist aus -NH-, einer Einfachbindung, die benachbarte Atome verbindet, $-SO_2-$, -CO-, $-SO_2NR'-$, -CONR'- und $-CH_2NR'COCH_2NR'-$;

"$X_2$" ausgewählt ist aus einer Einfachbindung, die benachbarte Atome verbindet, einer Alkylen-Gruppe, die 20 oder weniger Kohlenstoffatome aufweist, einer Alkenylen-Gruppe, die 20 oder weniger Kohlenstoffatome aufweist, einer ArylenGruppe, die 20 oder weniger Kohlenstoffatome aufweist, einem heteroaromatischen Ring, der 20 oder weniger Kohlenstoffatome aufweist, und denselben Gruppen, die jedoch Substituenten aufweisen (diese Gruppen können miteinander über eine divalente Bindungsgruppe verbunden sein, die ausgewählt ist aus -NR'-, -O-, $-SO_2-$ oder -CO-);

"$X_3$" ausgewählt ist aus einer Einfachbindung, die benachbarte Atome verbindet, $-SO_2NR'-$ und -CONR'-;

"$X_4$" ausgewählt ist aus einer Einfachbindung, die benachbarte Atome verbindet, einer Alkylengruppe, die 20 oder weniger Kohlenstoffatome aufweist, einer Alkenylengruppe, die 20 oder weniger Kohlenstoffatome aufweist, einer Arylengruppe, die 20 oder weniger Kohlenstoffatome aufwiest, und denselben Gruppen, die jedoch Substituenten aufweisen (diese Gruppen können miteinander über eine divalente Bindungsgruppe verbunden sein, die ausgewählt ist aus -NR'-, -O-, $-SO_2-$oder -CO-);

"$R_1$" und "$R_2$" unabhängig voneinander ausgewählt sind aus einem Wasserstoffatom, einer Alyklgruppe, die 20 oder weniger Kohlenstoffatome aufweist, einer Alkenylgruppe, die 20 oder weniger Kohlenstoffatome aufweist, und denselben Gruppen, die jedoch Substituenten aufweisen, und $R_1$ und $R_2$ einzeln zugegen sind, unter Bildung eines Rings vereinigt sind oder zusammen mit einem Stickstoffatom, einem Sauerstoffatom oder einem Schwefelatom unter Bildung eines Heterozyklus vereinigt sind; und

"R'" ausgewählt ist aus einem Wasserstoffatom, einer Alkylgrupe, die 20 oder weniger Kohlenstoffatome aufweist, einer Alkenylgruppe, die 20 oder weniger Kohlenstoffatome aufweist, einer Arylgruppe, die 20 oder weniger Kohlenstoffatome aufweist, und denselben Gruppen, die jedoch Substituenten aufweisen;

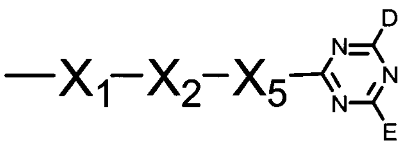

Formel (3)

worin "$X_1$" und "$X_2$" dieselbe Bedeutung haben, wie sie für Formel (2) definiert wurde;

"$X_5$" -NR'- oder -O- steht, vorausgesetzt, daß R' dieselbe Bedeutung hat, wie sie für Formel (2) definiert wurde; und

"D" und "E" unabhängig voneinander ausgewählt sind aus einer Gruppe, die durch die folgende Formel (4) wiedergegeben wird, einer Gruppe, die durch die folgende Formel (5) wiedergegeben wird, einer Gruppe, die durch die folgende Formel (6) wiedergegeben wird, $-O-(CH_2)_n-R_8$, $-OR_9$, $-NR_{10}R_{11}$, -Cl und -F;

"$R_8$" für einen Stickstoff enthaltenden Heterozyklus-Rest steht;

"R", "$R_{10}$" und "$R_{11}$" jeweils unabhängig voneinander ausgewählt sind aus einem Wasserstoffatom, einer Alkylgruppe, die 20 oder weniger Kohlenstoffatome aufweist, einer Alkenylgruppe, die 20 oder weniger Kohlenstoffatome aufweist, einer Arylgruppe, die 20 oder weniger Kohlenstoffatome aufweist und denselben Gruppen, die jedoch Substituenten aufweisen; und

"n" für eine ganze Zahl von 0 bis 20 steht;

vorausgesetzt, daß irgendeiner der Reste D und E eine Gruppe ist, die durch die folgende Formel (4) oder (5), $-O-(CH_2)_n-R_8$, $-OR_9$ oder $-NR_{10}R_{11}$ wiedergegeben wird;

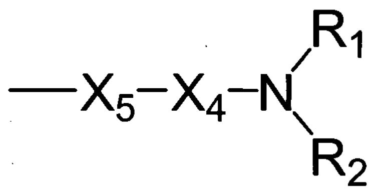

Formel (4)

worin $X_5$, $X_4$, $R_1$ und $R_2$ dieselben Bedeutungen haben, wie sie für die Formel (2) oder Formel (3) definiert wurden;

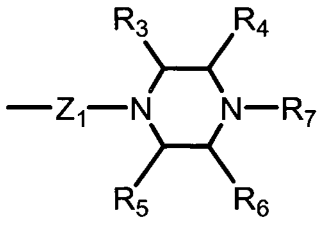

Formel (5)

worin "$Z_1$" ausgewählt ist aus einer Einfachbindung , die den Triazin-Ring mit einem Stickstoffatom verbindet, -N'-, -NR'-G-CO-, -NR'-G-CONR''-, -NR'-G-$SO_2$-, -NR'-G-$SO_2$NR''-, -O-G-CO-, -O-G-CONR'-, -O-G-$SO_2$- und -O-G-$SO_2$NR'-;
"G" ausgewählt ist aus einer Alkylengruppe, die 20 oder weniger Kohlenstoffatome aufweist, einer Alkenylengruppe, die 20 oder weniger Kohlenstoffatome aufweist, einer Arylengruppe, die 20 oder weniger Kohlenstoffatome aufweist und denselben Gruppen, die jedoch Substituenten aufweisen; und
"R'" und "R''" jeweils unabhängig voneinander ausgewählt sind aus einem Wasserstoffatom, einer Alkylgruppe, die 20 oder weniger Kohlenstoffatome aufweist, einer Alkenylgruppe, die 20 oder weniger Kohlenstoffatome aufweist, einer Arylgruppe, die 20 oder weniger Kohlenstoffatome aufweist und denselben Gruppen, die jedoch Substituenten aufweisen;
$R_3$, $R_4$, $R_5$ und $R_6$ jeweils unabhängig voneinander ausgewählt sind aus einem Wasserstoffatom, einer Alkylgruppe, die 20 oder weniger Kohlenstoffatome aufweist, einer Alkenylgruppe, die 20 oder weniger Kohlenstoffatome aufweist, einer Arylgruppe, die 20 oder weniger Kohlenstoffatome aufweist und denselben Gruppen, die jedoch Substituenten aufweisen; und
"$R_7$" ausgewählt ist aus einer Alkylgruppe, die 20 oder weniger Kohlenstoffatome aufweist, einer Alkenylgruppe, die 20 oder weniger Kohlenstoffatome aufweist, und denselben Gruppen, die jedoch Substituenten aufweisen; und

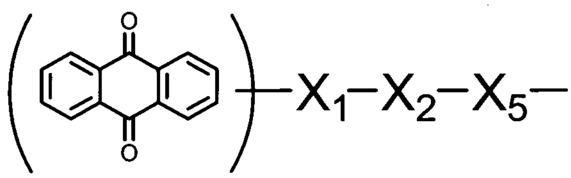

Formel (6)

worin "$X_1$", "$X_2$" und "$X_5$" dieselben Bedeutungen haben, wie sie für die Formel (2) oder Formel (3) definiert wurden.

**2.** Verfahren zur Herstellung einer Pigment-Zusammensetzung für Farbfilter nach Anspruch 1, worin das Pigmentderivat ein Anthrachinon-Derivat ist, das durch die folgende Formel (7) wiedergegeben wird:

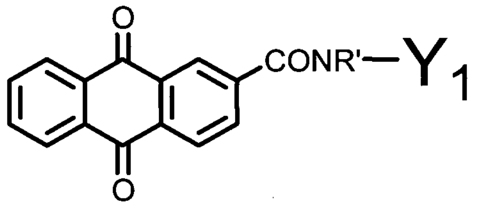

Formel (7)

worin $Y_1$ für eine Gruppe steht, die durch die folgende Formel (8) oder die folgende Formel (9) wiedergegeben wird:

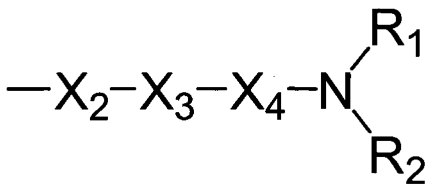

Formel (8)

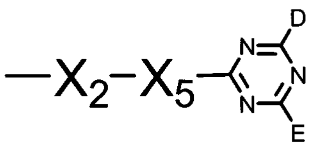

Formel (9)

worin $X_2$, $X_3$, $X_4$, $X_5$, $R_1$, $R_2$, D und E dieselben Bedeutungen haben, wie sie für die Formel (2) oder Formel (3) definiert wurden.

3. Verfahren zur Herstellung einer Pigment-Zusammensetzung für Farbfilter nach Anspruch 1 oder 2, worin der Gehalt des Pigmentderivats 0,5 Gew.-% bis 30 Gew.-% beträgt, basierend auf dem Gesamtgewicht des C.I. Pigment Red 177 und des Pigmentderivats.

4. Verfahren zur Herstellung einer Pigment-Zusammensetzung für Farbfilter, umfassend die Pigment-Zusammensetzung nach einem der Ansprüche 1 bis 3 und ein von C.I. Pigment Red 177 verschiedenes rotes Pigment oder ein oranges Pigment.

5. Verfahren zur Herstellung einer Pigment-Zusammensetzung für Farbfilter nach Anspruch 4, worin das von C.I. Pigment Red 177 verschiedene rote Pigment oder das orange Pigment wenigstens ein Pigment ist, das ausgewählt ist aus C.I. Pigment Red 254, Pigment Red 255, C.I. Pigment Red 264, C.I. Pigment Red 207, C.I. Pigment Red 48:1, C.I. Pigment Orange 71 und C.I. Pigment Orange 73.

6. Verfahren zur Herstellung einer Pigment-Zusammensetzung für Farbfilter, umfassend die Herstellungsschritte des Verfahrens zur Herstellung einer Pigment-Zusammensetzung nach irgendeinem der Ansprüche 1 bis 5 und Zugabe eines gelben Pigments.

7. Verfahren zur Herstellung einer Pigment-Zusammensetzung für Farbfilter nach Anspruch 6, worin das gelbe Pigment wenigstens ein Pigment ist, das ausgewählt ist aus C.I. Pigment Yellow 138, C.I. Pigment Yellow 139, C.I. Pigment Yellow 150, C.I. Pigment Yellow 185 und C.I. Pigment Yellow 13.

8. Verfahren zur Herstellung einer Pigment-Zusammensetzung für Farbfilter, umfassend die Herstellungsschritte des Verfahrens zur Herstellung einer Pigment-Zusammensetzung nach irgendeinem der Ansprüche 1 bis 7 und Zugabe eines Pigmentträgers, gebildet aus einem transparenten Harz, einer Vorstufe daraus oder einer Mischung davon.

## Revendications

1. Procédé de préparation d'une composition de pigments pour un filtre coloré, comprenant les étapes dans lesquelles :

on dissout, dans de l'acide sulfurique, le C.I. Pigment Red 177 et un pigment qui dérive de la formule Q-Am dont la structure principale « Q » est choisie parmi le groupe constitué par les formules suivantes (1) (i) à (viii) et qui possède un substituant basique ou neutre représenté par « -Am » dans laquelle « A » est choisi parmi un groupe phtalimidométhyle substitué ou non substitué, un groupe répondant à la formule suivante (2), un groupe répondant à la formule suivante (3) ou un groupe répondant à la formule H-$X_1$-$X_2$-$X_5$-, et « m » représente un entier de 1 à 8, dont de l'acide sulfurique;

on les mélange ensuite avec de l'eau pour induire une précipitation ; et

on élimine les composants acides ; dont de l'acide sulfurique ;

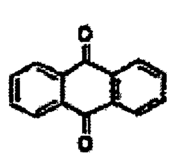
(i)
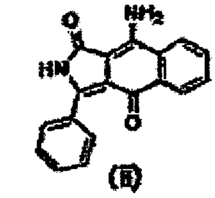
(ii)
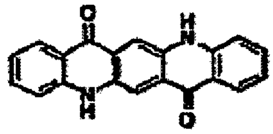
(iii)
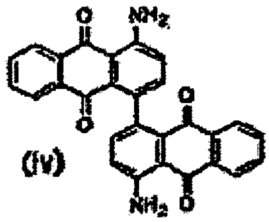
(iv)
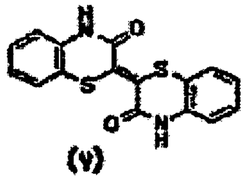
(v)
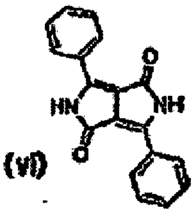
(vi)
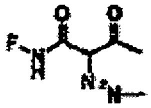
(vii)
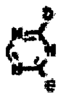
(viii)

Formule (1)

formules dans lesquelles « F » est choisi parmi un groupe phényle, un groupe phtalimide, un groupe benzimidazolone, un groupe naphtalimide et les mêmes groupes, mais qui possèdent des substituants ; et « $X_1$ », « $X_2$ », « $X_5$ », « D » et « E » ont les mêmes significations que celles définies pour les formules suivantes (2) et (3) :

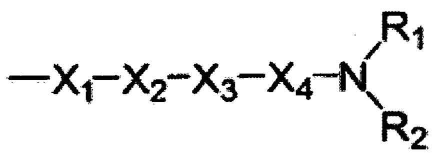

Formule (2)

dans laquelle « $X_1$ » est choisi parmi un groupe -NH-, une liaison simple reliant des atomes adjacents, un groupe -$SO_2$-, un groupe -CO-, un groupe -$SO_2$NR'-, un groupe -CONR'- et un groupe -$CH_2$NR'CO$CH_2$NR'- ;

« $X_2$ » est choisi parmi une liaison simple reliant des atomes adjacents, un groupe alkylène contenant 20 atomes de carbone ou moins, un groupe alcénylène contenant 20 atomes de carbone ou moins, un groupe arylène contenant 20 atomes de carbone ou moins, un noyau hétéroaromatique contenant 20 atomes de carbone ou moins, et les mêmes groupes, mais qui possèdent des substituants (ces groupes peuvent être liés les uns aux autres via un groupe de liaison divalent choisi parmi un groupe -NR'-, un atome d'oxygène, un groupe -$SO_2$ ou un groupe -CO-) ;

« $X_3$ » est choisi parmi une liaison simple reliant des atomes adjacents, un groupe -$SO_2$NR'- et un groupe -CONR'-,

« $X_4$ » est choisi parmi une liaison simple reliant des atomes adjacents, un groupe alkylène contenant 20 atomes de carbone ou moins, un groupe alcénylène contenant 20 atomes de carbone ou moins, un groupe arylène contenant 20 atomes de carbone ou moins, et les mêmes groupes, mais qui possèdent des substituants (ces groupes peuvent être liés les uns aux autres via un groupe de liaison divalent choisi parmi un groupe -NR'-, un atome d'oxygène, un groupe -$SO_2$ ou un groupe -CO-) ;

« $R_1$ » et « $R_2$ » sont choisis chacun de manière indépendante parmi un atome d'hydrogène, un groupe alkyle contenant 20 atomes de carbone ou moins, un groupe alcényle contenant 20 atomes de carbone ou moins, et les mêmes groupes, mais qui possèdent des substituants, et $R_1$ et $R_2$ sont présents de manière individuelle, sont joints pour former un cycle ou sont joints l'un à l'autre avec un atome d'azote, un atome d'oxygène ou un atome de soufre pour former un hétérocycle, et
« R' » est choisi parmi un atome d'hydrogène, un groupe alkyle contenant 20 atomes de carbone ou moins, un groupe alcényle contenant 20 atomes de carbone ou moins, un groupe aryle contenant 20 atomes de carbone ou moins, et les mêmes groupes, mais qui possèdent des substituants,

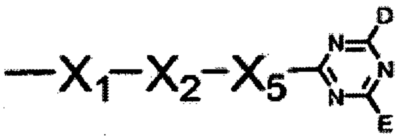

Formule (3)

dans laquelle « $X_1$ » et « $X_2$ » ont la même signification que celle définie pour la formule (2) ;
« $X_5$ » représente un groupe -NR'- ou un atome d'oxygène, avec cette condition que R' possède la même signification que celle définie pour la formule (2) ; et
« D » et « E » sont choisis chacun de manière indépendante parmi un groupe répondant à la formule suivante (4), un groupe répondant à la formule suivante (5), un groupe répondant à la formule suivante (6), un groupe $-O-(CH_2)_n-R_8$, un groupe $-OR_9$, un groupe $-NR_{10}R_{11}$, un atome de chlore et un atome de fluor ;
« $R_8$ » représente un résidu hétérocyclique contenant un atome d'azote,
« R », « $R_{10}$ » et « $R_{11}$ » sont choisis chacun de manière indépendante parmi un atome d'hydrogène, un groupe alkyle contenant 20 atomes de carbone ou moins, un groupe alcényle contenant 20 atomes de carbone ou moins, un groupe aryle contenant 20 atomes de carbone ou moins, et les mêmes groupes, mais qui possèdent des substituants, et
« n » représente un entier de 0 à 20 ;
avec cette condition que l'un quelconque des résidus D et E représente un groupe répondant à la formule suivante (4) ou (5), un groupe $-O-(CH_2)_n-R_8$, un groupe $-OR_9$ ou un groupe $-NR_{10}R_{11}$ ;

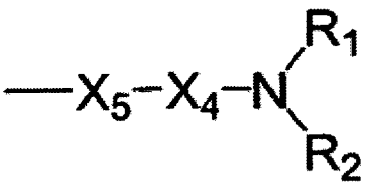

Formule (4)

dans laquelle $X_5$, $X_4$, $R_1$ et $R_2$ ont les mêmes significations que celles définies pour la formule (2) ou pour la formule (3),

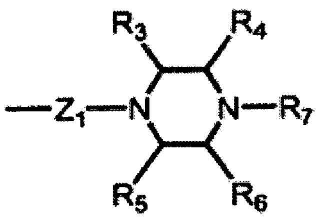

Formule (5)

dans laquelle « $Z_1$ » est choisi parmi une liaison simple qui relie le noyau triazine à un atome d'azote, un groupe -NR'-, un groupe -NR'-G-CO-, un groupe -NR'-G-CONR"-, un groupe -NR'-G-$SO_2$-, un groupe -NR'-G-$SO_2$NR"-, un groupe -O-G-CO-, un groupe -O-G-CONR'-, un groupe -O-G-$SO_2$- et un groupe -O-G-$SO_2$NR'-,
« G » est choisi parmi un groupe alkylène contenant 20 atomes de carbone ou moins, un groupe alcénylène contenant 20 atomes de carbone ou moins, un groupe arylène contenant 20 atomes de carbone ou moins, et les mêmes groupes, mais qui possèdent des substituants ; et
« R' » et « R" » sont choisis, chacun de manière indépendante parmi un atome d'hydrogène, un groupe alkyle contenant 20 atomes de carbone ou moins, un groupe alcényle contenant 20 atomes de carbone ou moins, un

groupe aryle contenant 20 atomes de carbone ou moins, et les mêmes groupes, mais qui possèdent des substituants ;

$R_3$, $R_4$, $R_5$ et $R_6$ sont choisis, chacun de manière indépendante parmi un atome d'hydrogène, un groupe alkyle contenant 20 atomes de carbone ou moins, un groupe alcényle contenant 20 atomes de carbone ou moins, un groupe aryle contenant 20 atomes de carbone ou moins, et les mêmes groupes, mais qui possèdent des substituants ; et

« $R_7$ » est choisi parmi un groupe alkyle contenant 20 atomes de carbone ou moins, un groupe alcényle contenant 20 atomes de carbone ou moins, et les mêmes groupes, mais qui possèdent des substituants, et

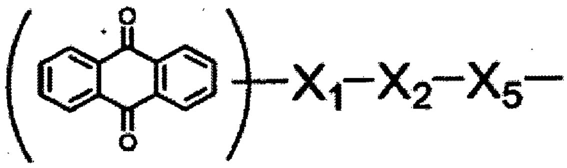

Formule (6)

dans laquelle $X_1$, $X_2$ et $X_5$ ont les mêmes significations que celles définies pour la formule (2) ou pour la formule (3).

**2.** Procédé pour préparer une composition de pigments pour un filtre coloré selon la revendication 1, dans lequel le dérivé de pigment est un dérivé d'anthraquinone répondant à la formule suivante (7) :

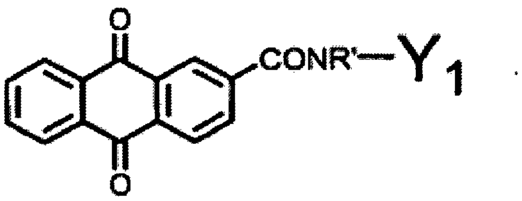

Formule (7)

dans laquelle $Y_1$ représente un groupe répondant à la formule suivante (8) ou à la formule suivante (9) :

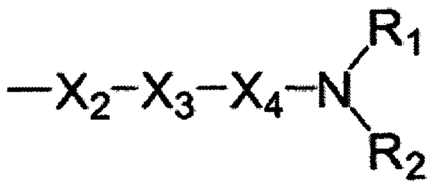

Formule (8)

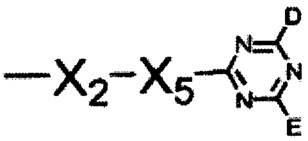

Formule (9)

dans laquelle $X_2$, $X_3$, $X_4$, $X_5$, $R_1$, $R_2$, D et E ont les mêmes significations que celles définies pour la formule (2) ou pour la formule (3).

**3.** Procédé de préparation d'une composition de pigments pour un filtre coloré selon la revendication 1 ou 2, dans lequel la teneur en dérivé de pigment s'élève de 0,5 % en poids à 30 % en poids basés sur le poids total du C.I. Pigment Red 177 et du dérivé de pigment.

**4.** Procédé de préparation d'une composition de pigments pour un filtre coloré, comprenant la composition de pigments selon l'une quelconque des revendications 1 à 3, est un pigment rouge autre que le C.I. Pigment Red 177 ou un pigment orange.

**5.** Procédé de préparation d'une composition de pigments pour un filtre coloré selon la revendication 4, dans lequel

le pigment rouge autre que le C.I. Pigment Red 177 ou le pigment orange représente au moins un pigment choisi parmi le C.I. Pigment Red 254, le Pigment Red 255, le C.I. Pigment Red 264, le C.I. Pigment Red 207, le C.I. Pigment Red 48:1, le C.I. Pigment Orange 71 et le C.I. Pigment Orange 73.

**6.** Procédé de préparation d'une composition de pigments pour un filtre coloré, comprenant les étapes de préparation du procédé pour la préparation d'une composition de pigments selon l'une quelconque des revendications 1 à 5, et l'addition d'un pigment jaune.

**7.** Procédé de préparation d'une composition de pigments pour un filtre coloré selon la revendication 6, dans lequel le pigment jaune représente au moins un pigment choisi parmi le C.I. Pigment Yellow 138, le C.I. Pigment Yellow 139, le C.I. Pigment Yellow 150, le C.I. Pigment Yellow 185 et le C.I. Pigment Yellow 13.

**8.** Procédé de préparation d'une composition de pigments pour un filtre coloré, comprenant les étapes de préparation du procédé pour la préparation d'une composition de pigments selon l'une quelconque des revendications 1 à 7, et l'addition d'un support de pigment réalisé à partir d'une résine transparente, d'un de ses précurseurs ou d'un de leurs mélanges.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 9208848 A
- JP 2005029633 A
- JP 9272812 A
- JP 10245501 A
- JP 10245502 A
- JP 2007138135 A
- JP 55108466 A
- JP 56167762 A
- JP 5331398 A
- JP 56032549 A
- JP 63305173 A
- JP 3825842 B